# EUROPEAN PATENT APPLICATION

(11) **EP 4 531 529 A2**
(43) Date of publication of application: **02.04.2025**
(21) Application number: 24201294.6
(22) Date of filing: 19.09.2024
(51) Int. Cl.: H10K 59/40, H10K 59/80

(54) **DISPLAY DEVICE**

(30) Priority: 26.09.2023 KR 20230129842
(71) Applicant: Samsung Display Co., Ltd., Gyeonggi-do 17113 (KR)
(72) Inventor: JUNG, Yang Ho, Giheung-gu, Yongin-si, Gyeonggi-do (KR); YUN, Sang Hyun, Giheung-gu, Yongin-si, Gyeonggi-do (KR); HONG, Pil Soon, Giheung-gu, Yongin-si, Gyeonggi-do (KR)
(74) Representative: Dr. Weitzel & Partner

(57) **Abstract**

A display device includes, a substrate (BS), a light emitting element layer (EML) on the substrate, including a plurality of light emitting elements emitting light, and a light control layer (LCL) on the light emitting element layer, including a light-transmitting layer (LT) transmitting the light and a light-shielding layer (LS) for shielding the light, wherein the light-transmitting layer includes, a first light-transmitting layer (LT1), a second light-transmitting layer (LT2) on the first light-transmitting layer, a third light-transmitting layer (LT3) on the second light-transmitting layer, and a fourth light-transmitting layer (LT4) on the third light-transmitting layer, wherein the light-shielding layer includes, a first portion (LS1a) between the second light-transmitting layers, a second portion (LS1b) on the first portion and between the fourth light-transmitting layers, a third portion(LS2a) on the second portion and between the fourth light-transmitting layers, and a fourth portion (LS2b) on the third portion, and wherein the second light-transmitting layer (LT2) covers an upper surface and sides of the first light-transmitting layer.

## Description

### BACKGROUND

### 1. Field

The present invention relates to a display device.

### 2. Description of the Related Art

With the advancement of the information age, consumer demand for display devices for displaying images has increased with various forms. A display device may be a flat panel display device such as a liquid crystal display device, a field emission display device and a light emitting display device. The light emitting display device may include an organic light emitting display device that includes an organic light emitting diode element as a light emitting element or a light emitting diode display device that includes an inorganic light emitting diode element such as a light emitting diode (LED) as a light emitting element.

In case of a display device for a vehicle, when images are displayed on the display device for a vehicle, which is placed in front of a driver or passenger, and is reflected on a windshield at night, it may interfere with the driver's driving, and it may be desirable to control a viewing angle of the image displayed on the display device for a vehicle. In addition, for privacy protection, it may be desirable to control the viewing angle of the image displayed on the display device for a vehicle so that the image displayed on the display device for a vehicle, which is placed in front of the driver, is not provided to the passenger.

The above information disclosed in this Background section is only for enhancement of understanding of the background and therefore the information discussed in this Background section does not necessarily constitute prior art.

### SUMMARY

Aspects of some embodiments of the present invention include a display device that may relatively improve reliability of a light control layer.

Aspects of some embodiments of the present invention include a display device that may relatively improve efficiency in a process of forming a light control layer.

The characteristics of embodiments according to the present invention are not limited to those mentioned above and additional characteristics of embodiments according to the present invention, which are not mentioned herein, will be more clearly understood by those skilled in the art from the following description of the present invention.

The present invention is defined by the features of claim 1. The dependent claims describe preferred embodiments.

According to some embodiments of the present invention, a display device includes, a substrate, a light emitting element layer on the substrate, including a plurality of light emitting elements for emitting light, and a light control layer on the light emitting element layer, including a light-transmitting layer for transmitting the light and a light-shielding layer configured to shield the light, wherein the light-transmitting layer includes, a first light-transmitting layer, a second light-transmitting layer on the first light-transmitting layer, a third light-transmitting layer on the second light-transmitting layer, and a fourth light-transmitting layer on the third light-transmitting layer, wherein the light-shielding layer includes, a first portion between sections of the second light-transmitting layer, a second portion on the first portion and between sections of the fourth light-transmitting layer, a third portion on the second portion and also between sections of the fourth light-transmitting layer, and a fourth portion on the third portion, and wherein the second light-transmitting layer covers an upper surface and sides of the first light-transmitting layer.

This means that the first light-transmitting layer and the second light-transmitting layer may be described as forming together a first combined light-transmitting layer, and the third light-transmitting layer and the fourth light-transmitting layer may be described as forming together a second combined light-transmitting layer. The first portion is between sections of the first combined light-transmitting layer and the second portion is between sections of the second combined light-transmitting layer. The third portion is also between the sections of the second combined light-transmitting layer.

According to some embodiments, a thickness of the first light-transmitting layer is smaller than a thickness of the second light-transmitting layer.

According to some embodiments, a width of the first light-transmitting layer is smaller than a width of the second light-transmitting layer.

According to some embodiments, a width of the first portion is the same as a width of the second portion.

According to some embodiments, a width of the first portion is greater than a width of the second portion.

According to some embodiments, the width of the second portion is greater than a width of the fourth portion.

According to some embodiments, the width of the second portion is smaller than a width of the fourth portion.

According to some embodiments, a width of the first portion is smaller than a width of the second portion.

According to some embodiments, the width of the second portion is smaller than a width of the fourth portion.

According to some embodiments, the width of the second portion is greater than a width of the fourth portion.

According to some embodiments, sides of at least one of the first to fourth light-transmitting layers or the first to fourth portions are inclined.

According to some embodiments, the display device may further comprise a first metal layer between the second portion and the third portion.

According to some embodiments of the present invention, a display device includes, a substrate, a light emitting element layer on the substrate, including a plurality of light emitting elements for emitting light, and a light control layer on the light emitting element layer, including a light-transmitting layer for transmitting the light and a light-shielding layer for shielding the light, wherein the light-transmitting layer includes, a first light-transmitting layer, a second light-transmitting layer on the first light-transmitting layer, a third light-transmitting layer on the second light-transmitting layer, and a fourth light-transmitting layer on the third light-transmitting layer, wherein the light-shielding layer includes, a first portion between sections of the first light-transmitting layer and between sections of the second light-transmitting layer, a second portion on the first portion and between sections of the third light-transmitting layer, a third portion on the second portion and also between sections of the third light-transmitting layer and between sections of the fourth light-transmitting layer, and a fourth portion on the third portion, and wherein the second light-transmitting layer is not in contact with sides of the first light-transmitting layer. That is, the second light-transmitting layer is free of a contact with sides of the first light-transmitting layer.

This means that also in this embodiment the first light-transmitting layer and the second light-transmitting layer form together a first combined light-transmitting layer, and the third light-transmitting layer and the fourth light-transmitting layer form together a second combined light-transmitting layer. The first portion is between sections of the first combined light-transmitting layer and the second portion is between sections of the second combined light-transmitting layer. The third portion is also between the sections of the second combined light-transmitting layer.

According to some embodiments, a width of the first light-transmitting layer is the same as a width of the second light-transmitting layer.

According to some embodiments, a width of the first light-transmitting layer is greater than a width of the second light-transmitting layer.

According to some embodiments, a width of a portion of the first portion, which portion overlaps the first light-transmitting layer in a direction along the substrate, is smaller than a width of a portion of the first portion, which portion overlaps the second light-transmitting layer in a direction along the substrate.

According to some embodiments, a width of the first light-transmitting layer is smaller than a width of the second light-transmitting layer.

According to some embodiments, a width of a portion of the first portion, which portion overlaps the first light-transmitting layer in a direction along the substrate, is greater than a width of a portion of the first portion, which portion overlaps the second light-transmitting layer in a direction along the substrate.

According to some embodiments, sides of at least one of the first to fourth light-transmitting layers or the first to fourth portions are inclined.

According to some embodiments, the display device may further comprise a first metal layer between the second portion and the third portion.

The display device according to some embodiments may relatively improve reliability of a light control layer.

The display device according to some embodiments may relatively improve efficiency in a process of forming a light control layer.

The characteristics of embodiments of according to the present invention are not limited to those mentioned above and more various characteristics are included in the following description of the present invention.

### BRIEF DESCRIPTION OF THE DRAWINGS

The above and other aspects and features of embodiments according to the present invention will become more apparent by describing in more detail aspects of some embodiments thereof with reference to the attached drawings, in which:
FIG. 1 is an exploded perspective view illustrating a display device according to some embodiments;
FIG. 2 is a plan view illustrating a display device according to some embodiments;
FIG. 3 is an exploded perspective view illustrating a display device according to some embodiments;
FIG. 4 is a schematic cross-sectional view illustrating a display device, which is taken along the line I-I' of FIG. 2;
FIG. 5 is a schematic view illustrating that a display device according to some embodiments is applied to a vehicle;
FIG. 6 is a cross-sectional view illustrating an example of a display panel according to some embodiments;
FIG. 7a is a cross-sectional view illustrating a display panel and a light control layer according to some embodiments;
FIG. 7b is a cross-sectional view illustrating a display panel and a light control layer according to some embodiments;
FIG. 8 is a cross-sectional view illustrating a display panel and a light control layer according to some embodiments;
FIG. 9 is a cross-sectional view illustrating a display panel and a light control layer according to some embodiments;
FIG. 10 is a cross-sectional view illustrating a display panel and a light control layer according to some embodiments;
FIG. 11 is a cross-sectional view illustrating a display panel and a light control layer according to some embodiments;
FIG. 12 is a cross-sectional view illustrating a display panel and a light control layer according to some embodiments;
FIG. 13 is a cross-sectional view illustrating a display panel and a light control layer according to some embodiments;
FIG. 14 is a cross-sectional view illustrating a display panel and a light control layer according to some embodiments;
FIG. 15 is a cross-sectional view illustrating a display panel and a light control layer according to some embodiments;
FIG. 16 is a cross-sectional view illustrating a display panel and a light control layer according to some embodiments;
FIG. 17 is a cross-sectional view illustrating a display panel and a light control layer according to further still another embodiment;
FIG. 18 is a flow chart illustrating a method for manufacturing a display device according to some embodiments illustrated with respect to FIG. 8;
FIGS. 19 and 20 are cross-sectional views illustrating aspects of the operation S100 of FIG. 18;
FIGS. 21 and 22 are cross-sectional views illustrating aspects of the operation S200 of FIG. 18;
FIGS. 23 and 24 are cross-sectional views illustrating aspects of the operation S300 of FIG. 18;
FIGS. 25 and 26 are cross-sectional views illustrating aspects of the operation S400 of FIG. 18; and
FIG. 27 is a cross-sectional view illustrating aspects of the operation S500 of FIG. 18.

### DETAILED DESCRIPTION

Aspects of some embodiments of the present invention will now be described more fully hereinafter with reference to the accompanying drawings, in which aspects of some embodiments of the invention are shown. This invention may, however, be embodied in different forms and should not be construed as limited to the embodiments set forth herein. Rather, these embodiments are provided so that this disclosure will be thorough and complete, and will filly convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

Hereinafter, aspects of some embodiments of the present invention will be described in more detail with reference to the accompanying drawings.

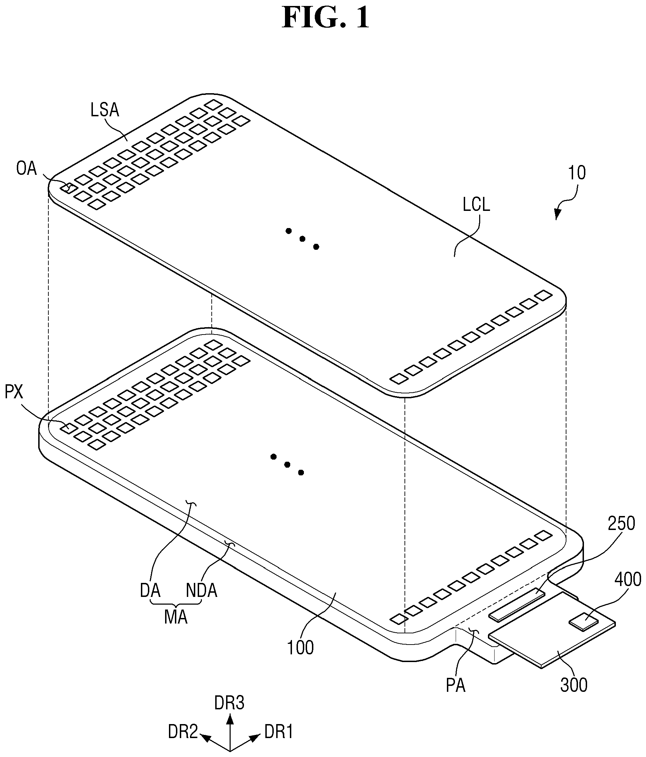

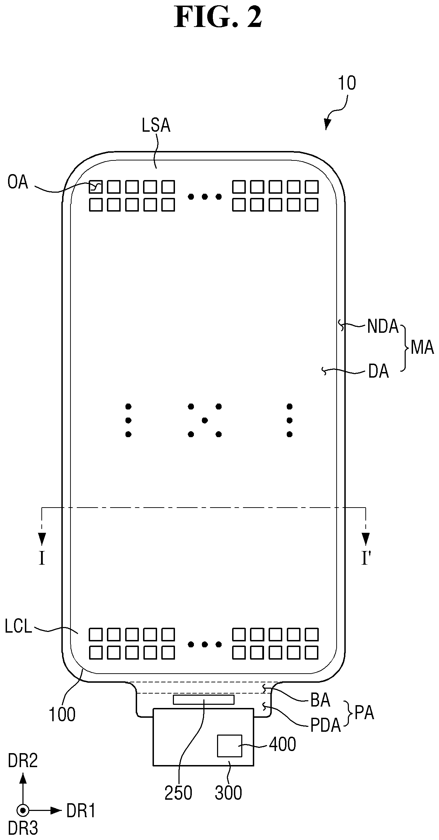

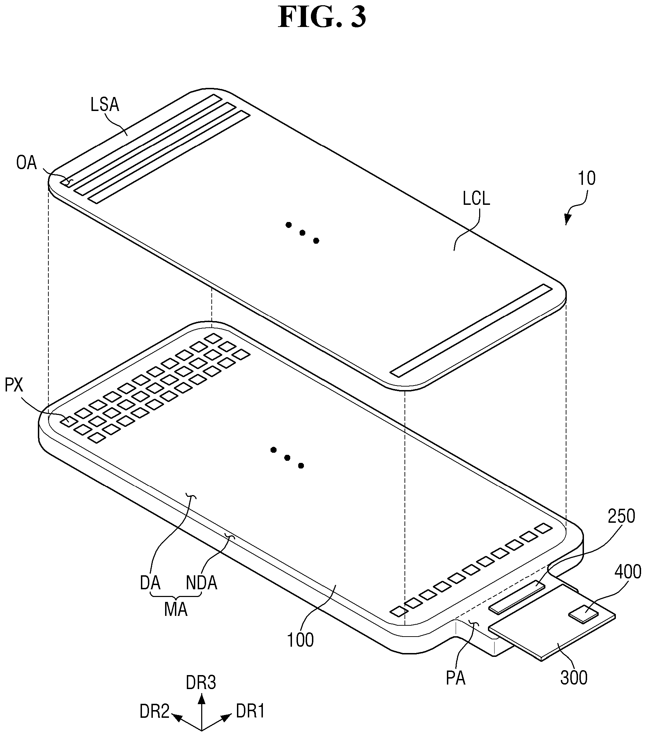

FIG. 1 is an exploded perspective view illustrating a display device according to some embodiments. FIG. 2 is a plan view illustrating a display device according to some embodiments. FIG. 3 is an exploded perspective view illustrating a display device according to some embodiments.

Referring to FIGS. 1 to 3, a display device 10 is a device that displays moving images (e.g., video images) or still images (e.g., static images), and may be used as a display screen of various products such as a television, a laptop computer, a monitor, an advertising board and a device for Internet of things (IoT) as well as portable electronic devices such as a mobile phone, a smart phone, a tablet personal computer (PC), a smart watch, a watch phone, a mobile communication terminal, an electronic diary, an electronic book, a portable multimedia player (PMP), a navigator and an ultra mobile PC (UMPC). The display device 10 may be any one of an organic light emitting display device, a liquid crystal display device, a plasma display device, a field emission display device, an electrophoresis display device, an electrowetting display device, a quantum dot light emitting display device and a micro LED display device. The following description will be based on that the display device 10 is an organic light emitting display device, but embodiments according to the present invention are not limited thereto.

The display device 10 according to some embodiments may include a display panel 100, a display driving circuit 250, a circuit board 300 and a touch driving circuit 400.

The display panel 100 may include a plurality of pixels PX arranged in a first direction DR1 and a second direction DR2. Each of the pixels PX may have a planar shape such as a rectangular shape, a square shape or a rhombus shape. For example, as shown in the drawing, each of the pixels PX may have a square planar shape, but is not limited thereto. Each of the pixels PX may have various shapes such as a polygonal shape, a circular shape and an oval shape on a plane.

In the shown drawing, the first direction DR1 and the second direction DR2 are horizontal directions, and cross each other. For example, the first direction DR1 and the second direction DR2 may be orthogonal to each other. A third direction DR3 crosses the first direction DR1 and the second direction DR2, and may be, for example, a vertical direction orthogonal to the first direction DR1 and the second direction DR2.

The display panel 100 may include a main area MA and a protrusion area PA protruded from one side of the main area MA.

The main area MA may be formed in a rectangular shaped plane having a short side in the first direction DR1 and a long side in the second direction DR2 crossing the first direction DR1. A corner at which the short side in the first direction DR1 and the long side in the second direction DR2 meet may be rounded to have a curvature (e.g., a set or predetermined curvature) or formed at a right angle. The planar shape of the display device 10 is not limited to the rectangular shape, and may be formed in another polygonal shape, a circular shape or an oval shape. The main area MA may be formed to be flat, but embodiments according to the present invention are not limited thereto. The main area MA may include a curved portion formed at left and right ends. In this case, the curved portion may have a constant curvature or a variable curvature.

The main area MA includes a display area DA in which pixels are formed to display images and a non-display area NDA that is a peripheral area (e.g., in a periphery or outside a footprint) of the display area DA.

Scan lines, data lines and a power line, which are connected to the pixels, as well as the pixels may be located in the display area DA. When the main area MA includes a curved portion, the display area DA may be located in the curved portion. In this case, images of the display panel 100 may be viewed even in the curved portion.

The non-display area NDA may be defined as an area from the outside of the display area DA to an edge of the display panel 100. A scan driver for applying scan signals to the scan lines, and link lines for connecting the data lines with the display driving circuit 250 may be located in the non-display area NDA.

The protrusion area PA may be protruded from one side of the main area MA. For example, as shown in FIG. 2, the protrusion area PA may be protruded from a lower side of the main area MA. A length of the protrusion area PA in the first direction DR1 may be shorter than a length of the main area MA in the first direction DR1.

The protrusion area PA may include a bending area BA and a pad area PDA. In this case, the pad area PDA may be located on one side of the bending area BA, and the main area MA may be located on the other side of the bending area BA. For example, the pad area PDA may be located below the bending area BA, and the main area MA may be located above the bending area BA.

The display panel 100 may be flexibly formed to be curved, bent, folded or rolled. Therefore, the display panel 100 may be bent in a thickness direction, i.e., the third direction DR3 in the bending area BA. In this case, one surface of the pad area PDA of the display panel 100 is directed upward before the display panel 100 is bent, but one surface of the pad area PDA of the display panel 100 is directed downward after the display panel 100 is bent. As a result, the pad area PDA is located below the main area MA, and thus may overlap the main area MA.

Pads electrically connected to the display driving circuit 250 and the circuit board 300 may be located in the pad area PDA of the display panel 100.

The display driving circuit 250 outputs signals and voltages for driving the display panel 100. For example, the display driving circuit 250 may supply data voltages to the data lines. In addition, the display driving circuit 250 may supply a power voltage to the power line and supply scan control signals to the scan driver. The display driving circuit 250 may be formed of an integrated circuit (IC), and then may be mounted on the display panel 100 in the pad area PDA in a chip on glass (COG) mode, a chip on plastic (COP) mode or an ultrasonic bonding mode, but is not limited thereto. For example, the display driving circuit 250 may be mounted on the circuit board 300.

The pads may include display pads electrically connected to the display driving circuit 250 and touch pads electrically connected to the touch lines.

The circuit board 300 may be attached onto the pads by using an anisotropic conductive film. Therefore, lead lines of the circuit board 300 may be electrically connected to the pads. The circuit board 300 may be a flexible printed circuit board, a printed circuit board or a flexible film such as a chip on film.

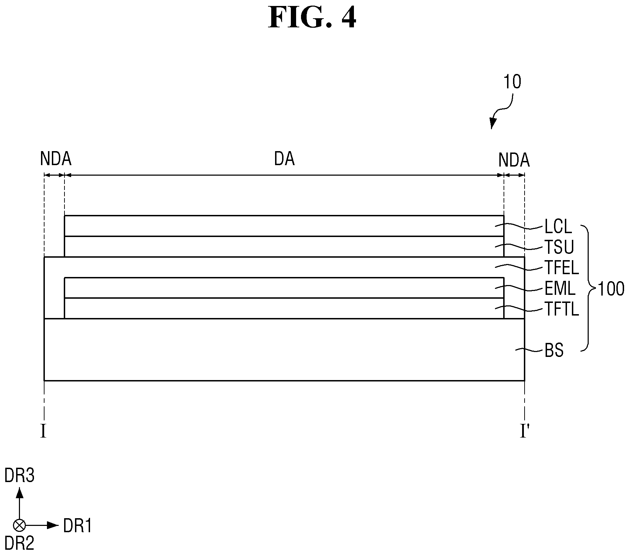

The touch driving circuit 400 may be connected to touch electrodes of a touch sensor layer TSU (see FIG. 4) of the display panel 100. The touch driving circuit 400 applies driving signals to the touch electrodes of the touch sensor layer TSU (see FIG. 4) and measures capacitance values of the touch electrodes. The driving signal may be a signal having a plurality of driving pulses. The touch driving circuit 400 may determine whether a touch is input depending on the capacitance values, and may calculate touch coordinates to which a touch is input.

The touch driving circuit 400 may be located on the circuit board 300. The touch driving circuit 400 may be formed of an integrated circuit (IC) and mounted on the circuit board 300.

In the display device 10 according to some embodiments, the display panel 100 may further include a light control layer LCL.

The light control layer LCL may be directly located on the main area MA of the display panel 100. For example, the light control layer LCL may be embedded in the display panel 100 and located directly on the main area MA of the display panel 100. As the light control layer LCL is embedded in the display panel 100, a thickness and manufacturing cost of the display device 10 may be reduced as compared with the case that a separate light control film is attached.

According to some embodiments, the light control layer LCL may be located on the display area DA of the main area MA. The light control layer LCL may adjust a viewing angle of light emitted from the display panel 100.

The light control layer LCL may include transmissive areas OA arranged in the first direction DR1 and the second direction DR2 and a non-transmissive area LSA surrounding the transmissive areas OA.

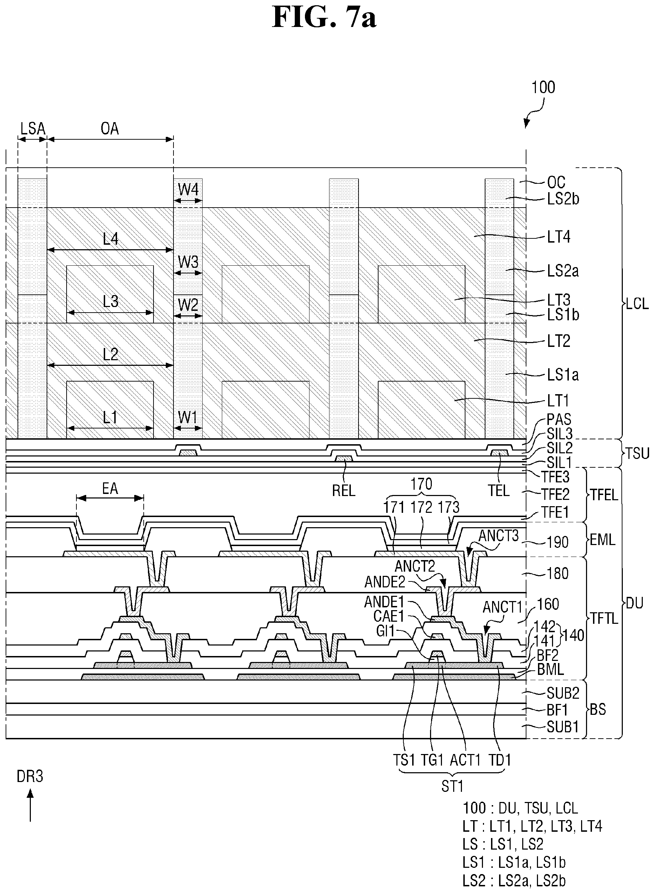

The transmissive areas OA may be areas in which a light-shielding layer LS (see FIG. 7a) is not located. The transmissive areas OA may be areas through which light is transmitted, and may extend along the third direction DR3.

Each of the transmissive areas OA may have a rectangular shape on a plane as shown in FIGS. 1 and 2, but embodiments according to the present invention are not limited thereto. Each of the transmissive areas OA may have a circular shape, an oval shape or a polygonal shape on a plane.

According to some embodiments, the transmissive areas OA may have a shape extending in the first direction DR1 or the second direction DR2. For example, as shown in FIG. 3, the transmissive areas OA may extend in the first direction DR1, and may be arranged along the second direction DR2. For another example, the transmissive areas OA may extend in the second direction DR2, and may be arranged along the first direction DR1.

As shown in FIG. 1, when the transmissive areas OA are arranged along the first direction DR1 and the second direction DR2, the viewing angle may be controlled in both the first direction DR1 and the second direction DR2. As shown in FIG. 3, when the transmissive areas OA are arranged along the first direction DR1 or the second direction DR2, the viewing angle may be controlled in the first direction DR1 or the second direction DR2. That is, various modifications may be made in the arrangement and shape of the transmissive areas OA depending on a required control direction of the viewing angle.

The non-transmissive area LSA may be the remaining area of the light control layer LCL except the transmissive area OA. The non-transmissive areas LSA may be areas in which the light-shielding layer LS (see FIG. 7a) is located.

In the drawing, the non-transmissive area LSA is shown as being arranged to surround the transmissive area OA, but is not limited thereto. In some embodiments, the non-transmissive area LSA may extend in the same direction as the transmissive area OA, and then may be arranged to be alternate with the transmissive area OA. For example, as shown in FIG. 3, when the transmissive area OA extends in the first direction DR1, the non-transmissive area LSA may extend in the first direction DR1, and may be arranged to alternate with the transmissive area OA in the second direction DR2.

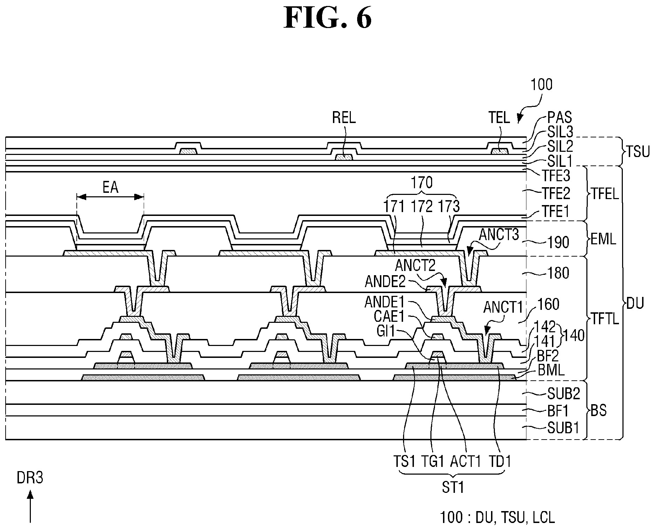

The light control layer LCL may include a light-shielding layer LS (see FIG. 7a) that shields light emitted from a light emitting layer 172 (see FIG. 6) of the display panel 100 and a light-transmitting layer LT (see FIG. 7a) that transmits the light. A detailed structure of the light control layer LCL will be described later with reference to FIG. 7a.

FIG. 4 is a schematic cross-sectional view illustrating a display device, which is taken along the line I-I' of FIG. 2.

Referring to FIG. 4, the display device 10 may include a display panel 100 in which the light control layer LCL is embedded. The display panel 100 may include a base member BS, a thin film transistor layer TFTL, a light emitting element layer EML, a thin film encapsulation layer TFEL, a touch sensor layer TSU, and a light control layer LCL.

The base member BS may include a substrate. The substrate may be made of an insulating material such as glass, quartz or a polymer resin. An example of the polymer material include polyethersulfone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (CAT), cellulose acetate propionate (CAP) or their combination. Alternatively, the substrate may include a metal material.

The substrate may be a rigid substrate, or may be a flexible substrate capable of being subjected to bending, folding, rolling or the like. When the substrate is a flexible substrate, the substrate may be formed of polyimide (PI), but is not limited thereto.

The thin film transistor layer TFTL may be located on the base member BS. Scan lines, data lines, power lines, scan control lines, routing lines connecting the pads with the data lines, etc. as well as thin film transistors of the respective pixels may be formed in the thin film transistor layer TFTL. Each of the thin film transistors may include a gate electrode, a semiconductor layer, a source electrode and a drain electrode.

The thin film transistor layer TFTL may be located in the display area DA and the non-display area NDA. For example, the thin film transistors of the respective pixels, the scan lines, the data lines and the power lines of the thin film transistor layer TFTL may be located in the display area DA. The scan control lines and the link lines of the thin film transistor layer TFTL may be located in the non-display area NDA.

The light emitting element layer EML may be located on the thin film transistor layer TFTL. The light emitting element layer EML may include pixels, which include a first electrode, a light emitting layer and a second electrode, and a pixel defining layer for defining the pixels. The light emitting layer may be an organic light emitting layer that includes an organic material. In this case, the light emitting layer may include a hole transporting layer, an organic light emitting layer and an electron transporting layer. When a voltage (e.g., a set or predetermined voltage) is applied to the first electrode through the thin film transistor of the thin film transistor layer TFTL and a cathode voltage is applied to the second electrode, holes and electrons are moved to the organic light emitting layer through the hole transporting layer and the electron transporting layer, respectively and are combined with each other in the organic light emitting layer to emit light. The pixels of the light emitting element layer EML may be located in the display area DA.

The thin film encapsulation layer TFEL may be located on the light emitting element layer EML. The thin film encapsulation layer TFEL may serve to prevent oxygen or moisture from being permeated into the light emitting element layer EML. To this end, the thin film encapsulation layer TFEL may include at least one inorganic layer. The inorganic layer may be a silicon nitride layer, a silicon oxynitride layer, a silicon oxide layer, a titanium oxide layer or an aluminum oxide layer, but is not limited thereto. In addition, the thin film encapsulation layer TFEL may serve to protect the light emitting element layer EML from particles such as dust. To this end, the thin film encapsulation layer TFEL may include at least one organic layer. The organic layer may be an acryl resin, an epoxy resin, a phenolic resin, a polyamide resin or a polyimide resin, but is not limited thereto.

The thin film encapsulation layer TFEL may be located in both the display area DA and the non-display area NDA. In detail, the thin film encapsulation layer TFEL may be arranged to cover the light emitting element layer EML of the display area DA and the non-display area NDA and cover the thin film transistor layer TFTL of the non-display area NDA.

The touch sensor layer TSU may be located on the thin film encapsulation layer TFEL. As the touch sensor layer TSU is located directly on the thin film encapsulation layer TFEL, the thickness of the display device 10 may be reduced as compared with the case that a separate touch panel including the touch sensor layer TSU is attached onto the thin film encapsulation layer TFEL.

The touch sensor layer TSU may include touch electrodes for sensing a touch of a user in a capacitance manner and touch lines for connecting the pads with the touch electrodes. For example, the touch sensor layer TSU may sense a touch of a user in a self-capacitance manner or a mutual capacitance manner.

The touch electrodes of the touch sensor layer TSU may be located in a touch sensor area that overlaps the display area DA. The touch lines of the touch sensor layer TSU may be located in a touch peripheral area that overlaps the non-display area NDA.

The light control layer LCL may be located on the touch sensor layer TSU. The light control layer LCL may be arranged to overlap the display area DA. The light control layer LCL may serve to absorb or shield light moving out of an angle (e.g., a set or predetermined angle) with respect to the third direction DR3 among the lights emitted from the light emitting element layer EML. That is, the light control layer LCL may control the viewing angle.

According to some embodiments, the display device 10 may further include a cover window. The cover window may be additionally located on the light control layer LCL. In this case, the light control layer LCL and the cover window may be attached to each other by a transparent adhesive member such as an optically clear adhesive (OCA) film.

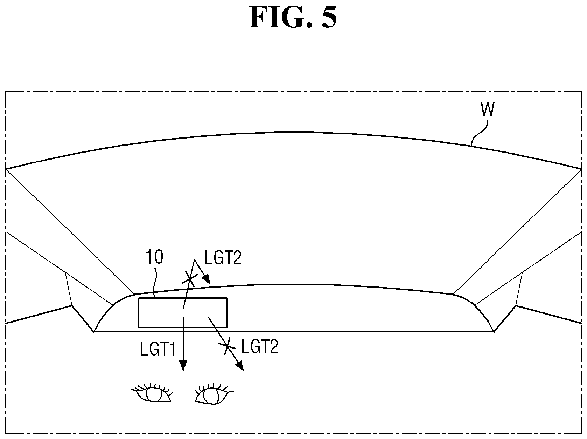

FIG. 5 is a schematic view illustrating that a display device according to some embodiments is applied to a vehicle.

Referring to FIG. 5, the display device 10 according to some embodiments may be, for example, a display device applied to a vehicle. The vehicle may include a vehicle body constituting external appearance of the vehicle and an indoor space defined by the vehicle body. The vehicle body may include a windshield W that protects a driver and a passenger from the outside and provides a field of view to the driver. As shown in FIG. 5, the display device 10 may be provided in the indoor space.

According to some embodiments, the display device 10 may be located on a dashboard provided in the indoor space. For example, the display device 10 may be located on the dashboard in front of the driver's seat to provide speed information, etc. to the driver, may be located on the dashboard in front of the passenger's seat to provide entertainment information, etc. to the passenger, or may be located at the center of the dashboard to provide map information and the like. FIG. 5 illustrates the display device 10 located on the dashboard in front of the driver's seat and a driver who views a display screen of the display device 10.

The driver may recognize (or watch) the display screen of the display device 10 through light LGT1 emitted from the display device 10 toward the driver. However, some light LGT2 of the light emitted from the display device 10 may be reflected toward the surrounding windshield W and then provided to the driver. In this case, an image reflected on the windshield W may interfere with driving of the driver. In case of the display device 10 according to some embodiments, a front viewing angle (viewing angle at which the driver is directed toward the front), particularly a vertical viewing angle, of the light LGT1 and LGT2 emitted from the display device 10 may be adjusted, so that some light LGT2 of the light emitted from the display device 10 may be prevented from being provided to the driver by being reflected toward the surrounding windshield W.

In addition, some light LGT2 of the light emitted from the display device 10 may be provided toward the passenger. In this case, the display device 10 may be vulnerable to privacy protection. However, in case of the display device 10 according to some embodiments, a front viewing angle (viewing angle at which the driver is directed toward the front), particularly a horizontal viewing angle, of the light LGT1 and LGT2 emitted from the display device 10 may be adjusted, so that the image displayed on the display device for a vehicle located in front of the driver may not be provided to the passenger.

The viewing angle may be adjusted through the light control layer LCL. The viewing angle may be limited to an angle range (e.g., a set or predetermined angle range) through the light control layer LCL. For example, when the driver is directed toward the front and a virtual line extending in a direction perpendicular to a display surface of the display device 10 is a normal line, the viewing angle may be an angle within 35° from the normal line. In some embodiments, an angle within 35° from the normal line may be defined as an effective viewing angle, but is not limited thereto.

FIG. 6 is a cross-sectional view illustrating an example of a display panel according to some embodiments. In FIG. 6, for convenience of description, the light control layer LCL is omitted.

Referring to FIG. 6, the display panel 100 may include a display layer DU and a touch sensor layer TSU. The display layer DU may include a base member BS, a thin film transistor layer TFTL, a light emitting element layer EML and a thin film encapsulation layer TFEL.

The base member BS may include a first substrate SUB1, a first buffer layer BF1 located on the first substrate SUB1 and a second substrate SUB2 located on the first buffer layer BF1.

The first substrate SUB1 and the second substrate SUB2 may be made of an insulating material such as glass, quartz or a polymer resin. An example of the polymer material may include polyethersulfone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (CAT), cellulose acetate propionate (CAP) or their combination. Alternatively, the substrate may include a metal material.

Each of the first substrate SUB1 and the second substrate SUB2 may be a rigid substrate, or may be a flexible substrate capable of being subjected to bending, folding, rolling or the like. When the substrate is a flexible substrate, the substrate may be formed of polyimide (PI), but embodiments according to the present invention are not limited thereto.

The first buffer layer BF1 may be a layer for protecting the first thin film transistor ST1 and the light emitting layer 172 from moisture permeated through the first substrate SUB1 and the second substrate SUB2, which are vulnerable to moisture permeation. The first buffer layer BF1 may include a plurality of inorganic layers that are alternately stacked. For example, the first buffer layer BF1 may be formed of a multi-layer in which one or more inorganic layers of a silicon nitride layer, a silicon oxynitride layer, a silicon oxide layer, a titanium oxide layer and an aluminum oxide layer are alternately stacked.

The thin film transistor layer TFTL may include a lower metal layer BML, a second buffer layer BF2, a first thin film transistor ST1, a first gate insulating layer GI1, a first interlayer insulating layer 141, a first capacitor electrode CAE1, a second interlayer insulating layer 142, a first anode connection electrode ANDE1, a first organic layer 160, a second anode connection electrode ANDE2, and a second organic layer 180.

The lower metal layer BML may be located on the second substrate SUB2. The lower metal layer BML may be arranged to overlap a first active layer ACT1 of the first thin film transistor ST1 in the third direction DR3 in order to prevent a leakage current from occurring when light is incident on the first active layer ACT1 of the first thin film transistor ST1. The lower metal layer BML may be formed of a single layer or multi-layer made of one of molybdenum (Mo), aluminum (Al), chromium (Cr), gold (Au), titanium (Ti), nickel (Ni), neodymium (Nd) and copper (Cu), or their alloy. The lower metal layer BML may be omitted.

The second buffer layer BF2 may be located on the lower metal layer BML. The second buffer layer BF2 is a layer for protecting the first thin film transistor ST1 and the light emitting layer 172 from moisture permeated through the first substrate SUB1 and the second substrate SUB2, which are vulnerable to moisture permeation. The second buffer layer BF2 may include a plurality of inorganic layers that are alternately stacked. For example, the second buffer layer BF2 may be formed of a multi-layer in which one or more inorganic layers of a silicon nitride layer, a silicon oxynitride layer, a silicon oxide layer, a titanium oxide layer and an aluminum oxide layer are alternately stacked.

The first active layer ACT1 of the first thin film transistor ST1 may be located on the second buffer layer BF2. The first active layer ACT1 of the first thin film transistor ST1 includes polycrystalline silicon, monocrystalline silicon, low temperature polycrystalline silicon, amorphous silicon or an oxide semiconductor. Since the first active layer ACT1 of the first thin film transistor ST1 exposed without being covered by the first gate insulating layer GI1 is doped with impurities or ions, the first active layer ACT1 of the first thin film transistor ST1 may have conductivity. Therefore, a first source electrode TS1 and a first drain electrode TD1 of the first active layer ACT1 of the first thin film transistor ST1 may be formed.

The first gate insulating layer GI1 may be located on the first active layer ACT1 of the first thin film transistor ST1. In FIG. 5, the first gate insulating layer GI1 is illustrated as being located between the first gate electrode TG1 and the first active layer ACT1 of the first thin film transistor ST1, but is not limited thereto. The first gate insulating layer GI1 may be located between the first interlayer insulating layer 141 and the first active layer ACT1 and between the first interlayer insulating layer 141 and the second buffer layer BF2. The first gate insulating layer GI1 may be formed of an inorganic layer, for example, a silicon nitride layer, a silicon oxynitride layer, a silicon oxide layer, a titanium oxide layer or an aluminum oxide layer.

The first gate electrode TG1 of the first thin film transistor ST1 may be located on the first gate insulating layer GI1. The first gate electrode TG1 of the first thin film transistor ST1 may overlap the first active layer ACT1 in the third direction DR3. The first gate electrode TG1 of the first thin film transistor ST1 may be formed of a single layer or multi-layer made of any one of molybdenum (Mo), aluminum (Al), chromium (Cr), gold (Au), titanium (Ti), nickel (Ni), neodymium (Nd) and copper (Cu), or their alloy.

The first interlayer insulating layer 141 may be located on the first gate electrode TG1 of the first thin film transistor ST1. The first interlayer insulating layer 141 may be formed of an inorganic layer, for example, a silicon nitride layer, a silicon oxynitride layer, a silicon oxide layer, a titanium oxide layer or an aluminum oxide layer. The first interlayer insulating layer 141 may include a plurality of inorganic layers.

The first capacitor electrode CAE1 may be located on the first interlayer insulating layer 141. The first capacitor electrode CAE1 may overlap the first gate electrode TG1 of the first thin film transistor ST1 in the third direction (Z-axis direction). Since the first interlayer insulating layer 141 has a dielectric constant (e.g., a set or predetermined dielectric constant), a capacitor may be formed by the first capacitor electrode CAE1, the first gate electrode TG1 and the first interlayer insulating layer 141 located between the first capacitor electrode CAE1 and the first gate electrode TG1. The first capacitor electrode CAE1 may be formed of a single layer or multi-layer made of any one of molybdenum (Mo), aluminum (Al), chromium (Cr), gold (Au), titanium (Ti), nickel (Ni), neodymium (Nd) and copper (Cu), or their alloy.

The second interlayer insulating layer 142 may be located on the first capacitor electrode CAE1. The second interlayer insulating layer 142 may be formed of an inorganic layer, for example, a silicon nitride layer, a silicon oxynitride layer, a silicon oxide layer, a titanium oxide layer or an aluminum oxide layer. The second interlayer insulating layer 142 may include a plurality of inorganic layers.

The first anode connection electrode ANDE1 may be located on the second interlayer insulating layer 142. The first anode connection electrode ANDE1 may be connected to the first drain electrode TD1 of the first thin film transistor ST1 through a first anode contact hole ANCT1, which exposes the first drain electrode TD1 of the first thin film transistor ST1, by passing through the first interlayer insulating layer 141 and the second interlayer insulating layer 142. The first anode connection electrode ANDE1 may be formed of a single layer or multi-layer made of any one of molybdenum (Mo), aluminum (Al), chromium (Cr), gold (Au), titanium (Ti), nickel (Ni), neodymium (Nd) and copper (Cu), or their alloy.

The first organic layer 160 for planarization may be located on the first anode connection electrode ANDE1. The first organic layer 160 may be formed of an organic layer such as acryl resin, epoxy resin, phenolic resin, polyamide resin and polyimide resin.

The second anode connection electrode ANDE2 may be located on the first organic layer 160. The second anode connection electrode ANDE2 may be connected to the second anode connection electrode ANDE2 through a second anode contact hole ANT2, which exposes the first anode connection electrode ANDE1, by passing through the first organic layer 160. The second anode connection electrode ANDE2 may be formed of a single layer or multi-layer made of any one of molybdenum (Mo), aluminum (Al), chromium (Cr), gold (Au), titanium (Ti), nickel (Ni), neodymium (Nd) and copper (Cu), or their alloy.

The second organic layer 180 may be located on the second anode connection electrode ANDE2. The second organic layer 180 may be formed of an organic layer such as acryl resin, epoxy resin, phenolic resin, polyamide resin and polyimide resin.

In FIG. 6, the first thin film transistor ST1 is formed in a top gate mode in which the first gate electrode TG1 is positioned above the first active layer ACT1, but is not limited thereto. The first thin film transistor ST1 may be formed in a bottom gate mode in which the first gate electrode TG1 is located below the first active layer ACT1 or a double gate mode in which the first gate electrode TG1 is located above and below the first active layer ACT1.

The light emitting element layer EML may be located on the second organic layer 180. The light emitting element layer EML may include light emitting elements 170 and a bank 190. Each of the light emitting elements 170 may include a first light emitting electrode 171, a light emitting layer 172 and a second light emitting electrode 173.

The first light emitting electrode 171 may be formed on the second organic layer 180. The first light emitting electrode 171 may be connected to the second anode connection electrode ANDE2 through a third anode contact hole ANCT3, which exposes the second anode connection electrode ANDE2, by passing through the second organic layer 180.

The first light emitting electrode 171 may be formed on the second organic layer 180. The first light emitting electrode 171 may be connected to the second anode connection electrode ANDE2 through a third anode contact hole ANT3, which exposes the second anode connection electrode ANDE2, by passing through the second organic layer 180.

In a top emission structure in which light is emitted toward the second light emitting electrode 173 based on the light emitting layer 172, the first light emitting electrode 171 may be formed of a metal material having high reflectivity, such as a stacked structure (Ti/Al/Ti) of aluminum and titanium, a stacked structure (ITO/AI/ITO) of aluminum and ITO, an APC alloy and a stacked structure (ITO/APC/ITO) of the APC alloy and ITO. The APC alloy is an alloy of silver (Ag), palladium (Pd) and copper (Cu).

The bank 190 may be formed to partition the first light emitting electrode 171 on the second organic layer 180 in order to serve to define a light emission area EA. The bank 190 may be formed to cover an edge of the first light emitting electrode 171. The bank 190 may be formed of an organic layer such as acryl resin, epoxy resin, phenolic resin, polyamide resin and polyimide resin.

The light emission area EA refers to an area in which the first light emitting electrode 171, the light emitting layer 172 and the second light emitting electrode 173 are sequentially stacked so that holes from the first light emitting electrode 171 and electrons from the second light emitting electrode 173 are combined with each other in the light emitting layer 172 to emit light.

The light emitting layer 172 is formed on the first light emitting electrode 171 and the bank 190. The light emitting layer 172 may include an organic material to emit light of a color (e.g., a set or predetermined color). For example, the light emitting layer 172 may include a hole transporting layer, an organic material layer, and an electron transporting layer.

The second light emitting electrode 173 may be located on the light emitting layer 172. The second light emitting electrode 173 may be formed to cover the light emitting layer 172. The second light emitting electrode 173 may be a common layer commonly formed in all of the light emission areas EA. According to some embodiments, a capping layer may be formed on the second light emitting electrode 173.

In the top emission structure, the second light emitting electrode 173 may be formed of a transparent conductive oxide (TCO) such as indium tin oxide (ITO) and indium zinc oxide (IZO) or a semi-transmissive conductive material such as magnesium (Mg), silver (Ag) or an alloy of magnesium (Mg) and silver (Ag). When the second light emitting electrode 173 is formed of a semi-transmissive conductive material, light emission efficiency may be enhanced by a micro cavity.

The thin film encapsulation layer TFEL may be located on the second light emitting electrode 173. The thin film encapsulation layer TFEL may include at least one inorganic layer to prevent oxygen or moisture from being permeated into the light emitting element layer. The thin film encapsulation layer TFEL may also include at least one organic layer to protect the light emitting element layer from particles such as dust. For example, the thin film encapsulation layer TFEL may include a first encapsulation layer TFE1, a second encapsulation layer TFE2, and a third encapsulation layer TFE3.

The first encapsulation layer TFE1 (e.g., the first inorganic encapsulation layer) may be located on the second light emitting electrode 173. The first encapsulation layer TFE1 may be an inorganic layer of a single layer or multi-layer. The first encapsulation layer TFE1 may be formed of a multi-layer or single layer, in which one or more inorganic layers of a silicon nitride layer, a silicon oxynitride layer, a silicon oxide layer, a titanium oxide layer and an aluminum oxide layer are alternately stacked.

The second encapsulation layer TFE2 (e.g., the first organic encapsulation layer) may be located on the first encapsulation layer TFE1. The second encapsulation layer TFE2 may be an organic layer of a single layer or multi-layer. The second encapsulation layer TFE2 may include a polymer-based material. The polymer-based material may include polyethylene terephthalate, polyethylene naphthalate, polycarbonate, polyimide, polyethylene sulfonate, polyoxymethylene, polyarylate, hexamethyldisiloxane, acrylic resin (e.g., polymethyl methacrylate, polyacrylic acid, etc.) or any combination thereof.

The third encapsulation layer TFE3 (e.g., the second inorganic encapsulation layer) may be located on the second encapsulation layer TFE2. The third encapsulation layer TFE3 may be an inorganic layer of a single layer or multi-layer. The third encapsulation layer TFE3 may include the same material as that of the first encapsulation layer TFE1. For example, the third encapsulation layer TFE3 may be formed of a multi-layer or single layer, in which one or more inorganic layers of a silicon nitride layer, a silicon oxynitride layer, a silicon oxide layer, a titanium oxide layer and an aluminum oxide layer are alternately stacked.

A thickness of the second encapsulation layer TFE2 may be greater than that of the first encapsulation layer TFE1 and the third encapsulation layer TFE3. For example, the second encapsulation layer TFE2 may have a thickness of 3.3µm to 6.6µm, and the first encapsulation layer TFE1 and the third encapsulation layer TFE3 may have a thickness of 0.55µm to 1.1 µm, but the present invention is not limited thereto.

The touch sensor layer TSU may be located on the thin film encapsulation layer TFEL. The touch sensor layer TSU may include a plurality of touch electrodes for sensing a touch of a user in a capacitance manner and touch lines for connecting the plurality of touch electrodes with the touch driving circuit. For example, the touch sensor layer TSU may sense a touch of a user in a mutual capacitance manner or a self-capacitance manner.

According to some embodiments, the touch sensor layer TSU may be located on a separate substrate located on the display layer DU. In this case, the substrate for supporting the touch sensor layer TSU may be an encapsulation member for encapsulating the display layer DU.

The plurality of touch electrodes of the touch sensor layer TSU may be located in the touch sensor area that overlaps the display area. The touch lines of the touch sensor layer TSU may be located in the touch peripheral area that overlaps the non-display area.

The touch sensor layer TSU may include a first touch insulating layer SIL1, a first touch electrode REL, a second touch insulating layer SIL2, a second touch electrode TEL, and a third touch insulating layer SIL3.

The first touch insulating layer SIL1 may be located on the thin film encapsulation layer TFEL. The first touch insulating layer SIL1 may have insulating and optical functions. The first touch insulating layer SIL1 may include at least one inorganic layer. For example, the first touch insulating layer SIL1 may be an inorganic layer that includes at least one of a silicon nitride layer, a silicon oxynitride layer, a silicon oxide layer, a titanium oxide layer, or an aluminum oxide layer. Optionally, the first touch insulating layer SIL1 may be omitted.

The first touch electrode REL may be located on the first touch insulating layer SIL1. The first touch electrode REL may not overlap the light emitting element 170. The first touch electrode REL may be formed of a single layer of molybdenum (Mo), titanium (Ti), copper (Cu), aluminum (Al) or indium tin oxide (ITO), or may be formed of a stacked structure (Ti/Al/Ti) of aluminum and titanium, a stacked structure (ITO/AI/ITO) of aluminum and ITO, an APC alloy or a stacked structure (ITO/APC/ITO) of the APC alloy and ITO.

The second touch insulating layer SIL2 may cover the first touch electrode REL and the first touch insulating layer SIL1. The second touch insulating layer SIL2 may have insulating and optical functions. For example, the second touch insulating layer SIL2 may be formed of the material described as the first touch insulating layer SIL1.

The second touch electrode TEL may be located on the second touch insulating layer SIL2. The second touch electrode TEL may not overlap the light emitting element 170. The second touch electrode TEL may be formed of a single layer of molybdenum (Mo), titanium (Ti), copper (Cu), aluminum (Al) or indium tin oxide (ITO), or may be formed of a stacked structure (Ti/Al/Ti) of aluminum and titanium, a stacked structure (ITO/Al/ITO) of aluminum and ITO, an APC alloy or a stacked structure (ITO/APC/ITO) of the APC alloy and ITO.

The third touch insulating layer SIL3 may cover the second touch electrode TEL and the second touch insulating layer SIL2. The third touch insulating layer SIL3 may have insulating and optical functions. The third touch insulating layer SIL3 may be formed of the material described as the second touch insulating layer SIL2.

The first touch insulating layer SIL1, the second touch insulating layer SIL2 and the third touch insulating layer SIL3 may be inorganic layers, and their refractive indexes may be greater than or equal to a refractive index of the first encapsulating layer TFE1 and a refractive index of the third encapsulating layer TFE3, respectively. For example, the refractive indexes of the first touch insulating layer SIL1, the second touch insulating layer SIL2 and the third touch insulating layer SIL3 may be 1.55 to 1.7. In the present invention, the refractive index may be a value measured in a standard state of about 20°C and 1 atmosphere by using light of about 550nm.

In some embodiments, the first touch insulating layer SIL1, the second touch insulating layer SIL2 and the third touch insulating layer SIL3 may be organic layers. For example, the first touch insulating layer SIL1, the second touch insulating layer SIL2 and the third touch insulating layer SIL3 may be organic layers such as acryl resin, epoxy resin, phenolic resin, polyamide resin and polyimide resin.

The touch sensor layer TSU may further include a planarization layer PAS for planarization. The planarization layer PAS may be formed of an organic layer such as acryl resin, epoxy resin, phenolic resin, polyamide resin and polyimide resin.

A refractive index of the planarization layer PAS may be the same as that of any one of the first touch insulating layer SIL1, the second touch insulating layer SIL2 and the third touch insulating layer SIL3. For example, the refractive index of the planarization layer PAS may be 1.55 to 1.7, but is not limited thereto.

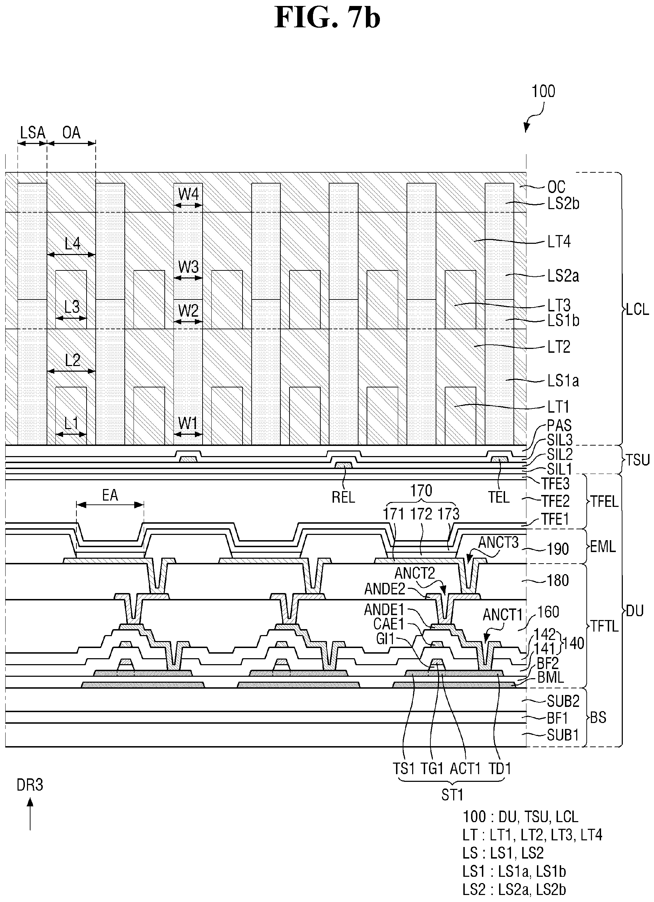

FIG. 7a is a cross-sectional view illustrating a display panel and a light control layer according to some embodiments. FIG. 7b is a cross-sectional view illustrating a display panel and a light control layer according to some embodiments.

Referring to FIGS. 7a and 7b in addition to FIGS. 1 to 3, the light control layer LCL may be located on the touch sensor layer TSU. The light control layer LCL may control the viewing angle of the light emitted from the light emitting layer 172. For example, when the light emitted from the light emitting layer 172 proceeds at an angle (e.g., a set or predetermined angle) or less with respect to the third direction DR3, the light may be emitted to the outside. On the other hand, when the light emitted from the light emitting layer 172 proceeds beyond an angle (e.g., a set or predetermined angle) with respect to the third direction DR3, the light may be absorbed or shielded by the light-shielding layer LS and thus may not be emitted to the outside.

The light control layer LCL may include a light-transmitting layer LT, a light-shielding layer LS and an overcoat layer OC.

The light-shielding layer LS may be located on the touch sensor layer TSU. The light-shielding layer LS may be located between the touch sensor layer TSU and the overcoat layer OC. The light-shielding layer LS may be located in the non-transmissive area LSA. According to some embodiments, the light-shielding layer LS may include a plurality of openings located in the transmissive area OA as shown in FIG. 1. In this case, the light-shielding layer LS may surround the light-transmitting layer LT. According to some embodiments, the light-shielding layer LS may be arranged to alternate with the light-transmitting layer LT in the first direction DR1 or the second direction DR2 as shown in FIG. 3.

The light-shielding layer LS may absorb or shield the light emitted from the light emitting layer 172. The light-shielding layer LS may include a light-shielding organic material. For example, the light-shielding layer LS is a photosensitive resin capable of absorbing or shielding light, and may include an organic material that includes an organic black pigment such as carbon black.

The light-transmitting layer LT may be located on the touch sensor layer TSU. The light-transmitting layer LT may be located between the touch sensor layer TSU and the overcoat layer OC. The light-transmitting layer LT may be located in the transmissive area OA. According to some embodiments, the light-transmitting layer LT may be located in the opening of the light-shielding layer LS as shown in FIG. 1, and may be surrounded by the light-shielding layer LS. According to some embodiments, as shown in FIG. 3, the light-transmitting layer LT may be arranged to alternate with the light-shielding layer LS in the first direction DR1 or the second direction DR2.

The light-transmitting layer LT may transmit the light emitted from the light emitting layer 172. The light-transmitting layer LT may include a transparent organic material. For example, the light-transmitting layer LT may include an organic layer such as an acryl resin, an epoxy resin, a phenolic resin, a polyamide resin and a polyimide resin. According to some embodiments, the light-transmitting layer LT may include silicon oxynitride or silicon oxide.

The overcoat layer OC may be located on the light-transmitting layer LT and the light-shielding layer LS. The overcoat layer OC may cover an upper surface and sides of a fourth portion LS2b of the light-shielding layer LS. The overcoat layer OC may protect the light-transmitting layer LT and the light-shielding layer LS. The overcoat layer OC may include an organic material. For example, the overcoat layer OC may include at least one of an acryl resin, an epoxy resin, a phenolic resin, a polyamide resin, or a polyimide resin.

According to some embodiments, as shown in FIG. 7a, the light-shielding layer LS may be located only in an area other than the light emission area EA. For example, the light-shielding layer LS may overlap the bank 190 in the third direction DR3. In this case, light, which has a low viewing angle, among the light generated from the light emitting layer 172 is less shielded, so that luminance of the display device 10 may be prevented from being reduced.

According to some embodiments, as shown in FIG. 7b, the light-shielding layer LS may be located in the light emission area EA and an area other than the light emission area EA. According to some embodiments, the light-shielding layer LS may be located only in the light emission area EA. When the light-shielding layer LS is also located in the light emission area EA, viewing angle control characteristics of the light control layer LCL may be improved. Therefore, a total thickness of the light control layer LCL, that is, a thickness of the light control layer LC in the third direction DR3 may be reduced.

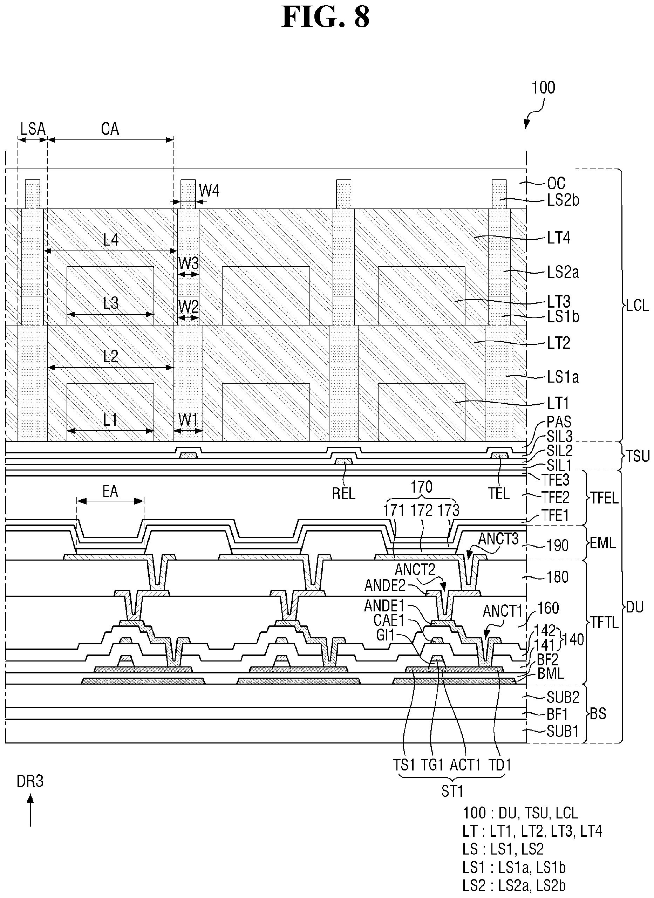

That is, according to viewing angle control characteristics and luminance characteristics of the display device 10, a position relation between the light-shielding layer LS and the light emission area EA may be formed in various ways. In the following embodiments described with reference to FIG. 8, etc., for convenience of description, the light-shielding layer LS is shown as being located only in an area other than the light emission area EA, but is not limited thereto. In the following embodiments, the light-shielding layer LS may be located in both the light emission area and the area other than the light emission area EA, or may be located only in the light emission area EA.

In the display device 10 according to some embodiments, the light-shielding layer LS and the light-transmitting layer LT may include a plurality of layers, respectively. For example, the light-shielding layer LS may include a first light-shielding layer LS1 and a second light-shielding layer LS2. The light-transmitting layer LT may include a first light-transmitting layer LT1, a second light-transmitting layer LT2, a third light-transmitting layer LT3, and a fourth light-transmitting layer LT4.

The first light-transmitting layer LT1 and the second light-transmitting layer LT2 may be located between the first light-shielding layers LS1. The first light-transmitting layer LT1 may be located on the touch sensor layer TSU. The second light-transmitting layer LT2 may be located on the first light-transmitting layer LT1. The second light-transmitting layer LT2 may cover an upper surface and sides of the first light-transmitting layer LT1. As the second light-transmitting layer LT2 covers the upper surface and the sides of the first light-transmitting layer LT1, durability of the light-transmitting layer LT may be improved.

A thickness of the first light-transmitting layer LT1 may be smaller than that of the second light-transmitting layer LT2 in the third direction DR3. For example, the thickness of the first light-transmitting layer LT1 may be in the range of about 5 *µ*m to about 10 *µ*m, and the thickness of the second light-transmitting layer LT2 may be in the range of about 10 *µ*m to about 20 *µ*m.

A width L1 of the first light-transmitting layer LT1 may be smaller than a width L2 of the second light-transmitting layer LT2. For example, the width L1 of the first light-transmitting layer LT1 may be in the range of about 3 *µ*m to 10 *µ*m, and the width L2 of the second light-transmitting layer LT2 may be in the range of about 40 *µ*m or less.

In some embodiments, the first light-transmitting layer LT1 and the second light-transmitting layer LT2 may include the same material, but are not limited thereto.

The first light-shielding layer LS1 may be located on the touch sensor layer TSU. The first light-shielding layer LS1 may include a first portion LS1a and second portion LS1b. The first portion LS1a may be located between the second light-transmitting layers LT2. The second portion LS1b may be located on the first portion LS1a. The second portion LS1b may be positioned to be higher than the first light-transmitting layer LT1 and the second light-transmitting layer LT2 in the third direction DR3. For example, the second portion LS1b may not overlap the first light-transmitting layer LT1 and the second light-transmitting layer LT2 in the horizontal direction. The second portion LS1b may be located between the fourth light-transmitting layers LT4.

A thickness of the first portion LS1a may be the same as that of the second light-transmitting layer LT2 in the third direction DR3. A thickness of the second portion LS1b may be smaller than that of the first portion LS1a in the third direction DR3. For example, the thickness of the first portion LS1a may be in the range of about 10 *µ*m to about 20 *µ*m.

A width W1 of the first portion LS1a and a width W2 of the second portion LS1b may be the same as each other. The width W1 of the first portion LS1a and the width W2 of the second portion LS1b may be smaller than the width L1 of the first light-transmitting layer LT1 and the width L2 of the second light-transmitting layer LT2. For example, the width W1 of the first portion LS1a and the width W2 of the second portion LS1b may be in the range of 10 *µ*m or less.

The third light-transmitting layer LT3 and the fourth light-transmitting layer LT4 may be located between the second light-shielding layers LS2. The third light-transmitting layer LT3 may be located on the second light-transmitting layer LT2. The fourth light-transmitting layer LT4 may be located on the third light-transmitting layer LT3. The fourth light-transmitting layer LT4 may cover an upper surface and sides of the third light-transmitting layer LT3. As the fourth light-transmitting layer LT4 covers the upper surface and the sides of the third light-transmitting layer LT3, durability of the light-transmitting layer LT may be improved.

A thickness of the third light-transmitting layer LT3 may be smaller than that of the fourth light-transmitting layer LT4 in the third direction DR3. For example, the thickness of the third light-transmitting layer LT3 may be in the range of about 5 *µ*m to 10 *µ*m, and the thickness of the fourth light-transmitting layer LT4 may be in the range of about 10 *µ*m to 20 ,um.

A width L3 of the third light-transmitting layer LT3 may be smaller than a width L4 of the fourth light-transmitting layer LT4. For example, the width L3 of the third light-transmitting layer LT3 may be in the range of about 3 *µ*m to 10 *µ*m, and the width L4 of the fourth light-transmitting layer LT4 may be in the range of about 40 *µ*m or less.

In some embodiments, the third light-transmitting layer LT3 and the fourth light-transmitting layer LT4 may include the same material, but are not limited thereto.

The thickness of the third light-transmitting layer LT3 may be the same as that of the first light-transmitting layer LT1 in the third direction DR3, and the thickness of the fourth light-transmitting layer LT4 may be the same as that of the second light-transmitting layer LT2 in the third direction DR3. The width L3 of the third light-transmitting layer LT3 may be the same as the width L1 of the first light-transmitting layer LT1, and the width L4 of the fourth light-transmitting layer LT4 may be the same as the width L2 of the second light-transmitting layer LT2.

The second light-shielding layer LS2 may be located on the first light-shielding layer LS1. The second light-shielding layer LS2 may include a third portion LS2a and a fourth portion LS2b. The third portion LS2a may be located between the fourth light-transmitting layers LT4. The fourth portion LS2b may be located on the third portion LS2a. An upper surface and sides of the fourth portion LS2b may be covered by the overcoat layer OC. The fourth portion LS2b may be positioned to be higher than the third light-transmitting layer LT3 and the fourth light-transmitting layer LT4 in the third direction DR3. For example, the fourth portion LS2b may not overlap the third light-transmitting layer LT3 and the fourth light-transmitting layer LT4 in the horizontal direction.

A thickness of the third portion LS2a may be the same as that of the fourth light-transmitting layer LT4 in the third direction DR3. The thickness of the fourth portion LS2b may be smaller than that of the third portion LS2a in the third direction DR3. For example, the thickness of the third portion LS2a may be in the range of about 10 *µ*m to 20 ,um.

A width W3 of the third portion LS2a and a width W4 of the fourth portion LS2b may be the same as each other. The width W3 of the third portion LS2a and the width W4 of the fourth portion LS2b may be smaller than the width L3 of the third light-transmitting layer LT3 and the width L4 of the fourth light-transmitting layer LT4. For example, the width W3 of the third portion LS2a and the width W4 of the fourth portion LS2b may be in the range of about 10 *µ*m or less.

The width W3 of the third portion LS2a may be the same as the width W1 of the first portion LS1a, and the width W4 of the fourth portion LS2b may be the same as the width W2 of the second portion LS1b.

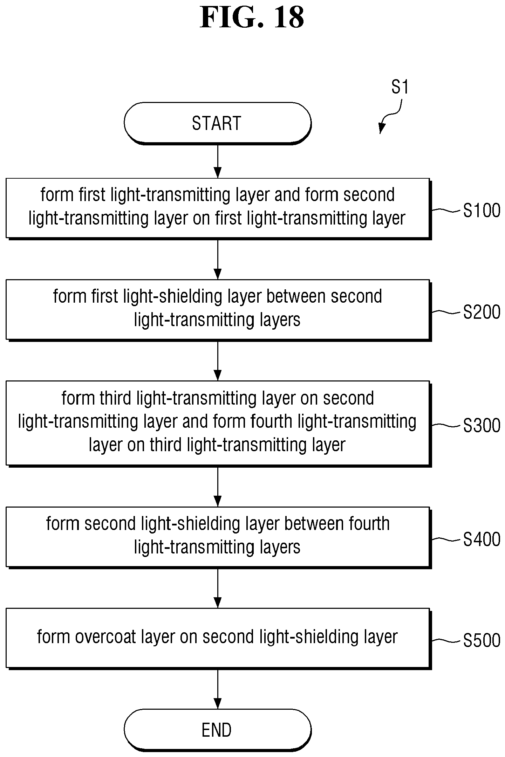

In the display device 10 according to some embodiments, the first to fourth light-transmitting layers LT1, LT2, LT3 and LT4, the first light-shielding layer LS1 and the second light-shielding layer LS2 are patterned through a photolithography process in the same manner as a method S1 (see FIG. 18) for manufacturing a display device, which will be described later, so that reliability of the light control layer LCL may be improved.

For example, in the display device according to some embodiments, because the light control layer LCL is formed of a plurality of layers, the time required for removing the light-transmitting layer LT positioned in the non-transmissive area LSA may be minimized or reduced in order to form the light control layer LCL having the same thickness. In addition, because the thickness from which the light-transmitting layer LT positioned in the non-transmissive area LSA is removed is reduced, formation of a bowing profile, which may occur due to isotropy of an etchant, may be minimized or reduced.

Meanwhile, when the light-transmitting layer LT positioned in the non-transmissive area LSA is removed, a photolithography process not dry etching may be used so that the process time and costs may be shortened, whereby process efficiency may be relatively improved. In addition, as the photolithography process is used, the width of the light-shielding layer LS may be more reduced than the case that the light-transmitting layer LT is etched through dry etching. Therefore, the light control layer LCL may be applied to the display device 10 of high resolution. In addition, because patterning is performed through the photolithography process, it is not necessary to remove the light-shielding layer LS, which is over-filled on the upper surface, through a polishing process, whereby the process costs may be reduced.

The process of forming the light control layer LCL will be described later with reference to the method S1 (see FIG. 18) for manufacturing the display device in FIG. 18.

Hereinafter, other aspects of the display device according to some embodiments will be described. In the following embodiments, the same elements as those of the previous embodiments will be referred to as the same reference numerals, and some redundant descriptions may be omitted or simplified and the following description will be based on differences from the previous embodiments.

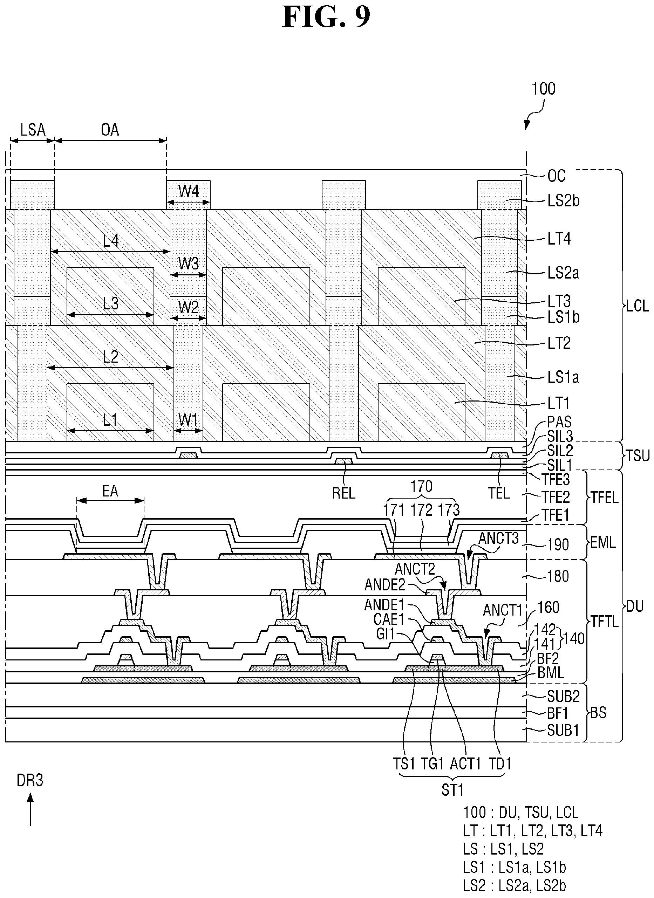

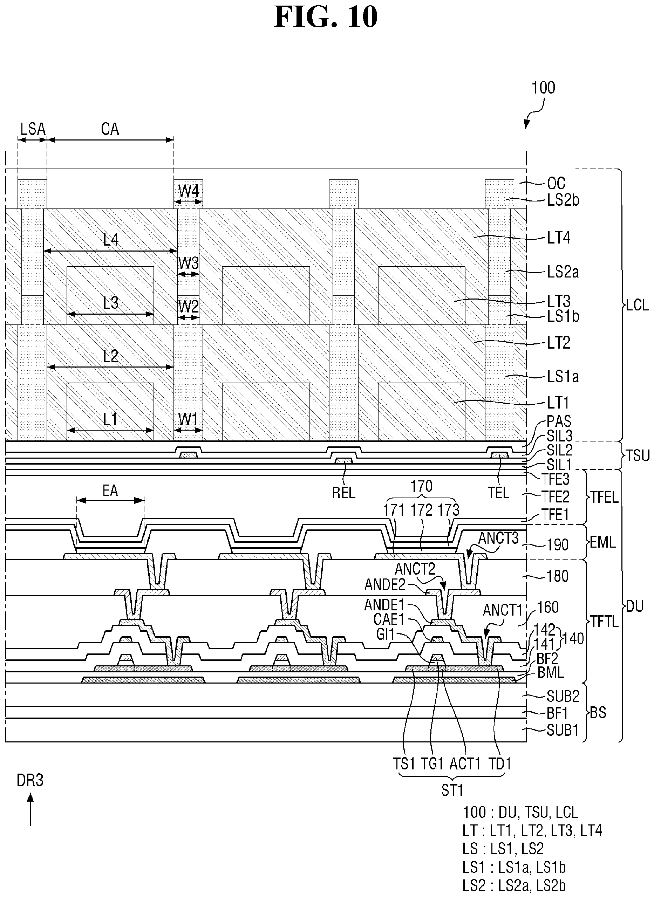

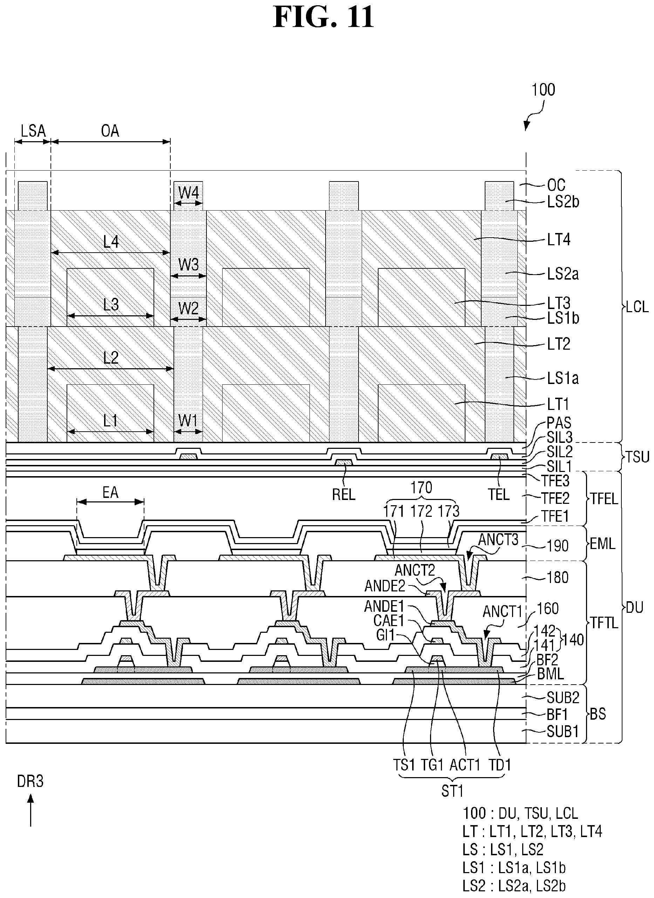

FIG. 8 is a cross-sectional view illustrating a display panel and a light control layer according to some embodiments. FIG. 9 is a cross-sectional view illustrating a display panel and a light control layer according to some embodiments. FIG. 10 is a cross-sectional view illustrating a display panel and a light control layer according to some embodiments. FIG. 11 is a cross-sectional view illustrating a display panel and a light control layer according to some embodiments.

Referring to FIGS. 8 to 11, the display device 10 according to the present embodiments is different from the display device 10 according to some embodiments described with reference to FIG. 7a in that the widths W1, W2, W3 and W4 of the first to fourth portions LS1a, LS1b, LS2a and LS2b of the light-shielding layer LS are different from one another.

In more detail, in case of the display device 10 according to some embodiments of FIG. 8, the width W1 of the first portion LS1a of the first light-shielding layer LS1 may be greater than the width W2 of the second portion LS1b. The width W3 of the third portion LS2a of the second light-shielding layer LS2 may be greater than the width W4 of the fourth portion LS2b. The width W2 of the second portion LS1b may be the same as the width W3 of the third portion LS2a.

Because the width W1 of the first portion LS1a is greater than the width W3 of the third portion LS2a, the width L2 of the second light-transmitting layer LT2 may be smaller than the width L4 of the fourth light-transmitting layer LT4.

In the display device 10 according to the embodiments of FIG. 8, as the width of the light-shielding layer LS becomes narrower upward, it may be advantageous for relatively improving luminance. For example, even though the light included in the effective viewing angle range described above is scattered and refracted in the light control layer LCL, the width of the light-shielding layer LS becomes narrower upward and thus the amount of the light emitted to the outside may be increased.

In case of the display device 10 according to the embodiments of FIG. 9, the width W1 of the first portion LS1a of the first light-shielding layer LS1 may be smaller than the width W2 of the second portion LS1b. The width W3 of the third portion LS2a of the second light-shielding layer LS2 may be smaller than the width W4 of the fourth portion LS2b. The width W2 of the second portion LS1b may be the same as the width W3 of the third portion LS2a.

Because the width W1 of the first portion LS1a is smaller than the width W3 of the third portion LS2a, the width L2 of the second light-transmitting layer LT2 may be greater than the width L4 of the fourth light-transmitting layer LT4.

In the display device 10 according to the embodiments of FIG. 9, as the width of the light-shielding layer LS becomes wider upward, it may be advantageous for controlling the viewing angle. For example, as the width of the light-shielding layer LS becomes wider upward, a size of the effective viewing angle may be smaller.

In case of the display device 10 according to the embodiments of FIG. 10, the width W1 of the first portion LS1a of the first light-shielding layer LS1 may be greater than the width W2 of the second portion LS1b. The width W3 of the third portion LS2a of the second light-shielding layer LS2 may be smaller than the width W4 of the fourth portion LS2b. The width W1 of the first portion LS1a may be the same as the width W4 of the fourth portion LS2b. The width W2 of the second portion LS1b may be the same as the width W3 of the third portion LS2a.

In the display device 10 according to the embodiments of FIG. 10, as the width of the light-shielding layer LS becomes narrower upward and then wider, the viewing angle may be controlled and at the same time luminance may be relatively improved.

In case of the display device 10 according to the embodiments of FIG. 11, the width W1 of the first portion LS1a of the first light-shielding layer LS1 may be smaller than the width W2 of the second portion LS1b. The width W3 of the third portion LS2a of the second light-shielding layer LS2 may be greater than the width W4 of the fourth portion LS2b. The width W1 of the first portion LS1a may be the same as the width W4 of the fourth portion LS2b. The width W2 of the second portion LS1b may be the same as the width W3 of the third portion LS2a.

In the display device 10 according to the embodiments of FIG. 11, as the width of the light-shielding layer LS becomes wider upward and then narrower, the viewing angle may be controlled and at the same time luminance may be relatively improved.

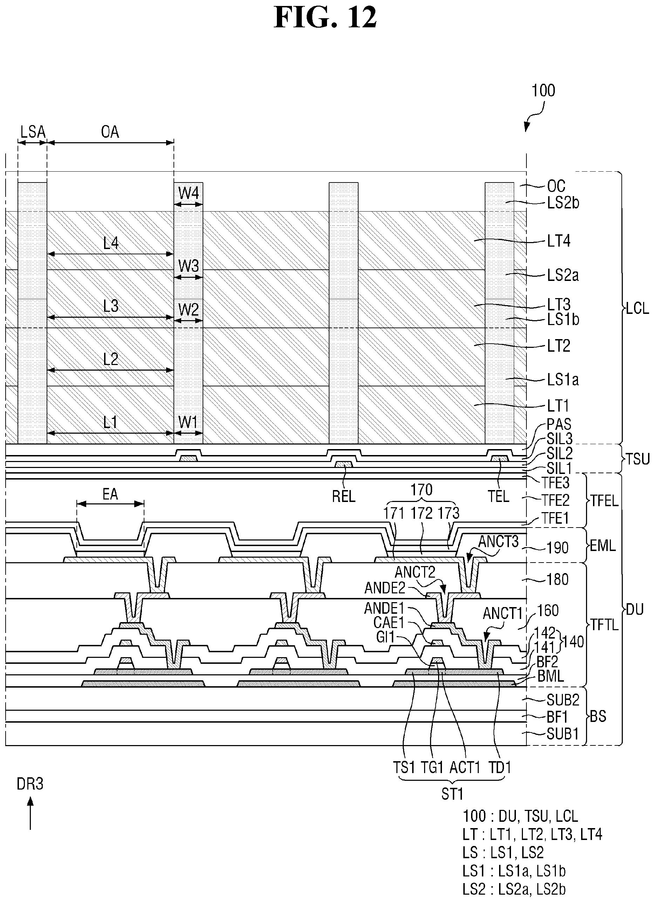

FIG. 12 is a cross-sectional view illustrating a display panel and a light control layer according to some embodiments.

Referring to FIG. 12, the display device 10 according to the present embodiments is different from the display device 10 according to embodiments described with reference to FIG. 7a in that the second light-transmitting layer LT2 is not in contact with the sides of the first light-transmitting layer LT1 and the fourth light-transmitting layer LT4 is not in contact with the sides of the third light-transmitting layer LT3.

In more detail, the second light-transmitting layer LT2 may be located on the first light-transmitting layer LT1. The second light-transmitting layer LT2 may be in contact with the upper surface of the first light-transmitting layer LT1. The second light-transmitting layer LT2 may not be in contact with the sides of the first light-transmitting layer LT1.

The fourth light-transmitting layer LT4 may be located on the third light-transmitting layer LT3. The fourth light-transmitting layer LT4 may be in contact with the upper surface of the third light-transmitting layer LT3. The fourth light-transmitting layer LT4 may not be in contact with the sides of the third light-transmitting layer LT3.

The width L2 of the second light-transmitting layer LT2 may be the same as the width L1 of the first light-transmitting layer LT1. The width L4 of the fourth light-transmitting layer LT4 may be the same as the width L3 of the third light-transmitting layer LT3. The widths L1, L2, L3 and L4 of the first to fourth light-transmitting layers LT1, LT2, LT3 and LT4 may be all the same as one another.

The first portion LS1a of the first light-shielding layer LS1 may be located between the first light-transmitting layer LT1 and the second light-transmitting layer LT2. The second portion LS1b may be located between the third light-transmitting layers LT3. The third portion LS2a may be located between the third light-transmitting layers LT3 and between the fourth light-transmitting layers LT4. The fourth portion LS2b may be covered by the overcoat layer OC.

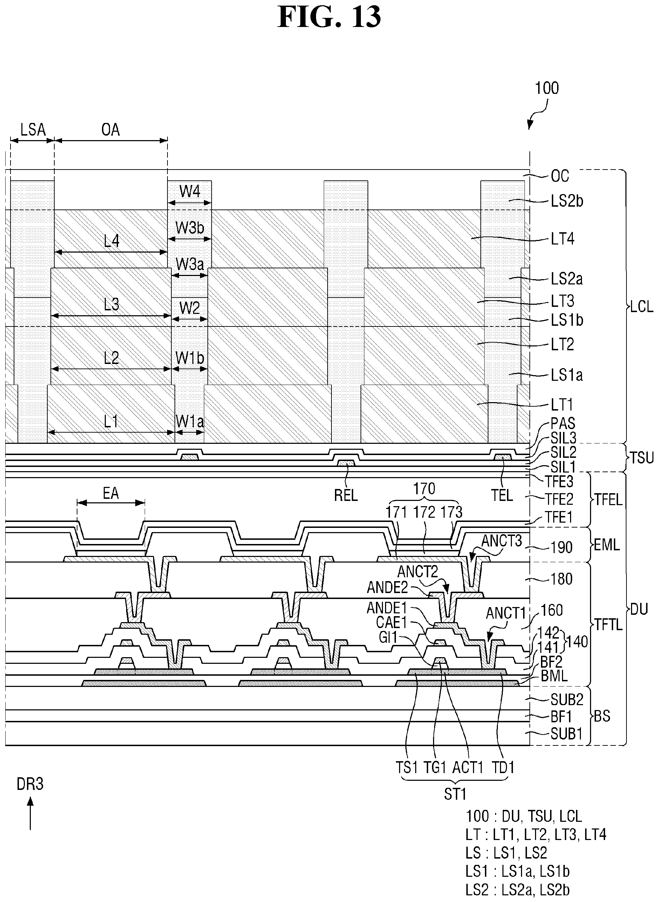

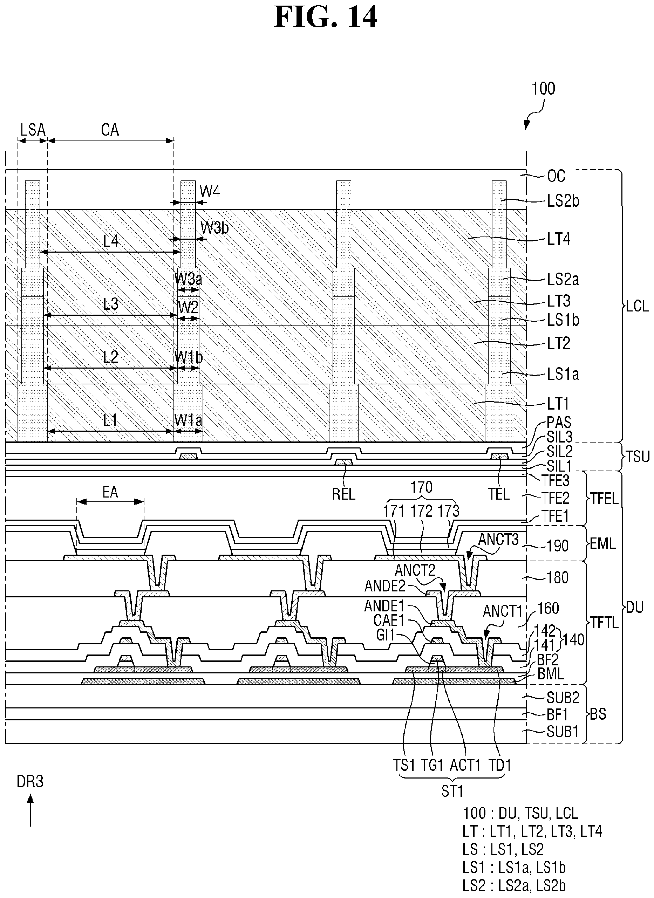

FIG. 13 is a cross-sectional view illustrating a display panel and a light control layer according to some embodiments. FIG. 14 is a cross-sectional view illustrating a display panel and a light control layer according to some embodiments.

Referring to FIGS. 13 and 14, the display device 10 according to the present embodiments is different from the display device 10 according to some embodiments described with reference to FIG. 12 in that the widths L1, L2, L3 and L4 of the first to fourth light-transmitting layers LT1, LT2, LT3 and LT4 are different from one another.

In more detail, in case of the display device 10 according to the embodiments of FIG. 13, the width L1 of the first light-transmitting layer LT1 may be greater than the width L2 of the second light-transmitting layer LT2. The width L3 of the third light-transmitting layer LT3 may be greater than the width L4 of the fourth light-transmitting layer LT4. According to some embodiments, the width L2 of the second light-transmitting layer LT2 may be the same as the width L3 of the third light-transmitting layer LT3.

Therefore, a width W1a of a portion of the first portion LS1a of the first light-shielding layer LS1, which overlaps the first light-transmitting layer LT1 in the horizontal direction, may be smaller than a width W1b of a portion of the first portion LS1a of the first light-shielding layer LS1, which overlaps the second light-transmitting layer LT2 in the horizontal direction. A width W3a of a portion of the third portion LS2a of the second light-shielding layer LS2, which overlaps the third light-transmitting layer LT3 in the horizontal direction, may be smaller than a width W3b of a portion of the third portion LS2a of the second light-shielding layer LS2, which overlaps the fourth light-transmitting layer LT4 in the horizontal direction. According to some embodiments, the width W2 of the second portion LS1b may be the same as the width W1b of the portion of the first portion LS1a, which overlaps the second light-transmitting layer LT2 in the horizontal direction, and the width W4 of the fourth portion LS2b may be the same as the width W3b of the portion of the third portion LS2a, which overlaps the fourth light-transmitting layer LT4 in the horizontal direction.

In the drawing, the width L2 of the second light-transmitting layer LT2 is shown as being the same as the width L3 of the third light-transmitting layer LT3, but is not limited thereto. For example, the width L2 of the second light-transmitting layer LT2 may be greater than the width L3 of the third light-transmitting layer LT3. In this case, the width W2 of the second portion LS1b may be greater than the width W1b of the portion of the first portion LS1a, which overlaps the second light-transmitting layer LT2 in the horizontal direction.

Also, in the drawing, the width W4 of the fourth portion LS2b is shown as being the same as the width W3b of the portion of the third portion LS2a, which overlaps the fourth light-transmitting layer LT4 in the horizontal direction, but is not limited thereto. For example, the width W4 of the fourth portion LS2b may be greater than the width W3b of the portion of the third portion LS2a, which overlaps the fourth light-transmitting layer LT4 in the horizontal direction.

In the display device 10 according to the embodiments of FIG. 13, as the width of the light-transmitting layer LT becomes narrower upward, the width of the light-shielding layer LS may become wider upward. Therefore, it may be advantageous for controlling the viewing angle.

In case of the display device 10 according to the embodiments of FIG. 14, the width L1 of the first light-transmitting layer LT1 may be smaller than the width L2 of the second light-transmitting layer LT2. The width L3 of the third light-transmitting layer LT3 may be smaller than the width L4 of the fourth light-transmitting layer LT4. According to some embodiments, the width L2 of the second light-transmitting layer LT2 may be the same as the width L3 of the third light-transmitting layer LT3.

Therefore, the width W1a of the portion of the first portion LS1a of the first light-shielding layer LS1, which overlaps the first light-transmitting layer LT1 in the horizontal direction, may be greater than the width W1b of the portion of the first portion LS1a, which overlaps the second light-transmitting layer LT2 in the horizontal direction. The width W3a of the third portion LS2a of the second light-shielding layer LS2, which overlaps the third light-transmitting layer LT3 in the horizontal direction, may be greater than the width W3b of the portion of the third portion LS2a, which overlaps the fourth light-transmitting layer LT4 in the horizontal direction. According to some embodiments, the width W2 of the second portion LS1b may be the same as the width W1b of the portion of the first portion LS1a, which overlaps the second light-transmitting layer LT2 in the horizontal direction, and the width W4 of the fourth portion LS2b may be the same as the width W3b of the portion of the third portion LS2a, which overlaps the fourth light-transmitting layer LT4 in the horizontal direction.

In the drawing, the width L2 of the second light-transmitting layer LT2 is shown as being the same as the width L3 of the third light-transmitting layer LT3, but is not limited thereto. For example, the width L2 of the second light-transmitting layer LT2 may be smaller than the width L3 of the third light-transmitting layer LT3. In this case, the width W2 of the second portion LS1b may be smaller than the width W1b of the portion of the first portion LS1a, which overlaps the second light-transmitting layer LT2 in the horizontal direction.

Also, in the drawing, the width W4 of the fourth portion LS2b is shown as being the same as the width W3b of the portion of the third portion LS2a, which overlaps the fourth light-transmitting layer LT4 in the horizontal direction, but is not limited thereto. For example, the width W4 of the fourth portion LS2b may be smaller than the width W3b of the portion of the third portion LS2a, which overlaps the fourth light-transmitting layer LT4 in the horizontal direction.

In the display device 10 according to the embodiments of FIG. 14, as the width of the light-transmitting layer LT becomes wider upward, the width of the light-shielding layer LS may become narrower upward. Therefore, it may be advantageous for relatively improving luminance.

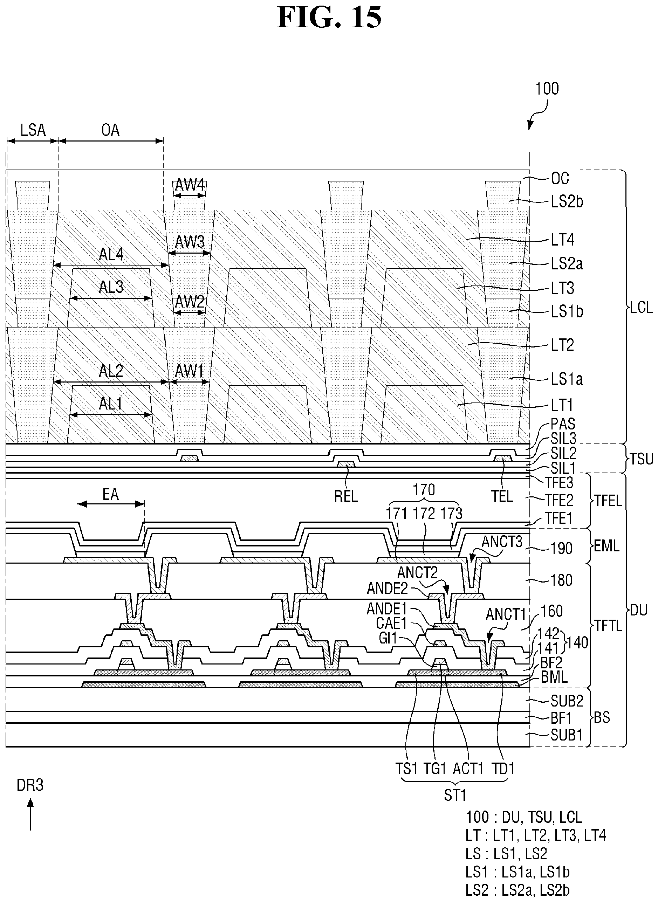

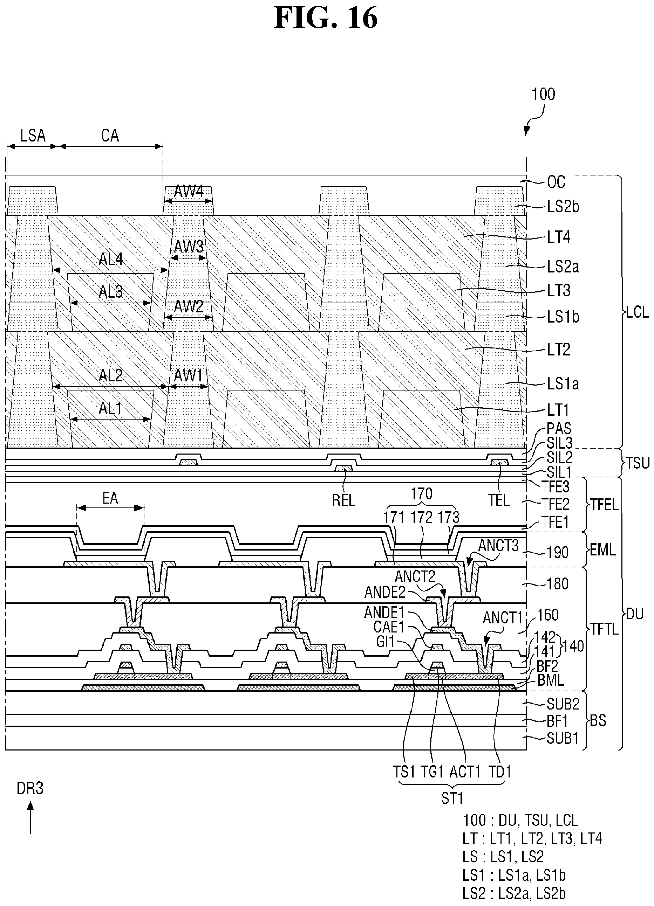

FIG. 15 is a cross-sectional view illustrating a display panel and a light control layer according to some embodiments. FIG. 16 is a cross-sectional view illustrating a display panel and a light control layer according to some embodiments.

Referring to FIG. 15 and FIG. 16, the display device 10 according to the present embodiments is different from the display device 10 according to embodiments described with reference to FIG. 7a in that the sides of the light-transmitting layer LT and the light-shielding layer LS are inclined.

In more detail, in case of the display device 10 according to the embodiments of FIG. 15, each of the first to fourth light-transmitting layers LT1, LT2, LT3 and LT4 may have a shape in which a width becomes narrower from a lower portion to an upper portion. Each of the first portion LS1a and the second portion LS2b of the first light-shielding layer LS1 and the third portion LS2a and the fourth portion LS2b of the second light-shielding layer LS2 may have a shape in which a width becomes wider from a lower portion to an upper portion.

The sides of the first to fourth light-transmitting layers LT1, LT2, LT3 and LT4 may have a normal-tapered shape. The sides of the first portion LS1a and the second portion LS2b of the first light-shielding layer LS1 and the third portion LS2a and the fourth portion SL2b of the second light-shielding layer LS2 may have a reverse-tapered shape.

An average width AL1 of the first light-transmitting layer LT1 may be smaller than an average width AL2 of the second light-transmitting layer LT2, and an average width AL3 of the third light-transmitting layer LT3 may be smaller than an average width AL4 of the fourth light-transmitting layer LT4. According to some embodiments, the average width AL1 of the first light-transmitting layer LT1 may be the same as the average width AL3 of the third light-transmitting layer LT3, and the average width AL2 of the second light-transmitting layer LT2 may be the same as the average width AL4 of the fourth light-transmitting layer LT4. The average width refers to an average value of widths in the horizontal direction.

An average width AW1 of the first portion LS1a may be greater than an average width AW2 of the second portion LS1b, and an average width AW3 of the third portion LS2a may be greater than an average width AW4 of the fourth portion LS2b.

In case of the display device 10 according to the embodiments of FIG. 16, each of the first to fourth light-transmitting layers LT1, LT2, LT3 and LT4 may have a shape in which a width becomes wider from a lower portion to an upper portion. The first portion LS1a and the second portion LS2b of the first light-shielding layer LS1 and the third portion LS2a and the fourth portion LS2b of the second light-shielding layer LS2 may have a shape in which a width becomes narrower from a lower portion to an upper portion.

The sides of the first to fourth light-transmitting layers LT1, LT2, LT3 and LT4 may have a reverse-tapered shape. The sides of the first portion LS1a and the second portion LS2b of the first light-shielding layer LS1 and the third portion LS2a and the fourth portion LS2b of the second light-shielding layer LS2 may have a normal-tapered shape.

The average width AL1 of the first light-transmitting layer LT1 may be smaller than the average width AL2 of the second light-transmitting layer LT2, and the average width AL3 of the third light-transmitting layer LT3 may be smaller than the average width AL4 of the fourth light-transmitting layer LT4. According to some embodiments, the average width AL1 of the first light-transmitting layer LT1 may be the same as the average width AL3 of the third light-transmitting layer LT3, and the average width AL2 of the second light-transmitting layer LT2 may be the same as the average width AL4 of the fourth light-transmitting layer LT4.

The average width AW1 of the first portion LS1a may be smaller than the average width AW2 of the second portion LS1b, and the average width AW3 of the third portion LS2a may be smaller than the average width AW4 of the fourth portion LS2b.

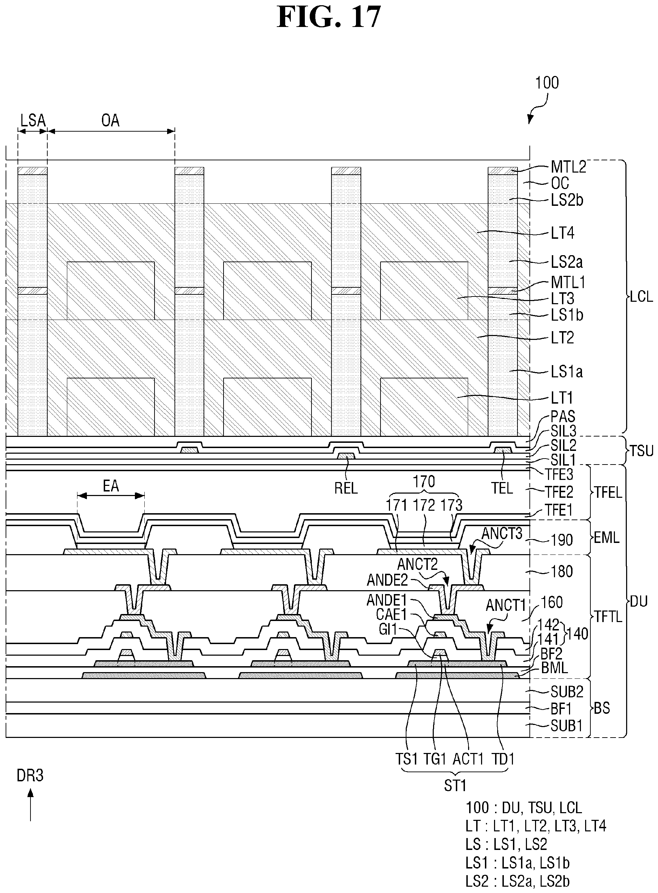

FIG. 17 is a cross-sectional view illustrating a display panel and a light control layer according to some embodiments.

Referring to FIG. 17, the display device 10 according to the present embodiments is different from the display device 10 according to embodiments described with reference to FIG. 7a in that the display device 10 according to the present embodiments further includes a first metal layer MTL1 and a second metal layer MTL2.

In more detail, the light control layer LCL may further include a first metal layer MTL1 and a second metal layer MTL2.

The first metal layer MTL1 may be located on the first light-shielding layer LS1. The first metal layer MTL1 may be located on the second portion LS1b of the first light-shielding layer LS1. The second metal layer MTL2 may be located on the second light-shielding layer LS2. The second metal layer MTL2 may be located on the fourth portion LS2b of the second light-shielding layer LS2.

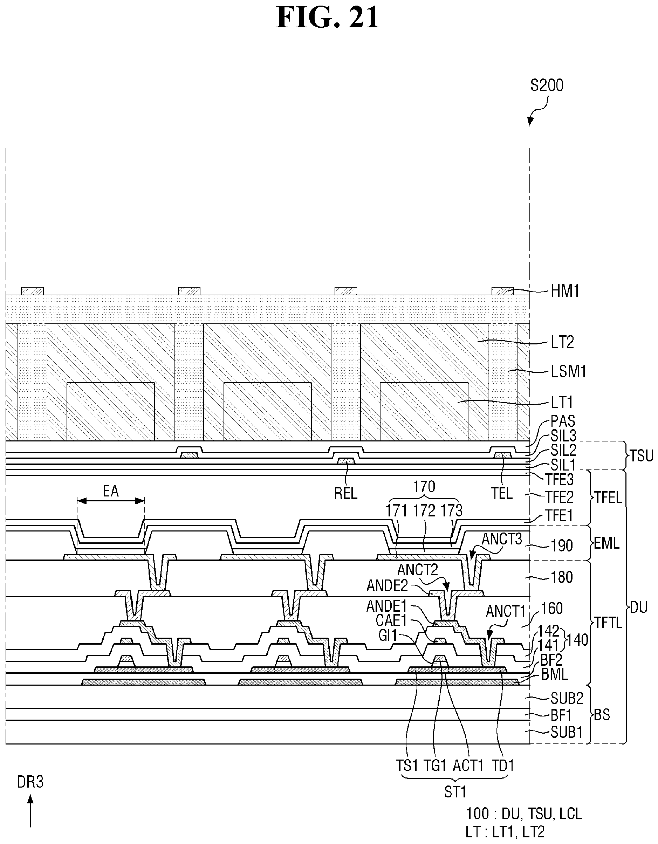

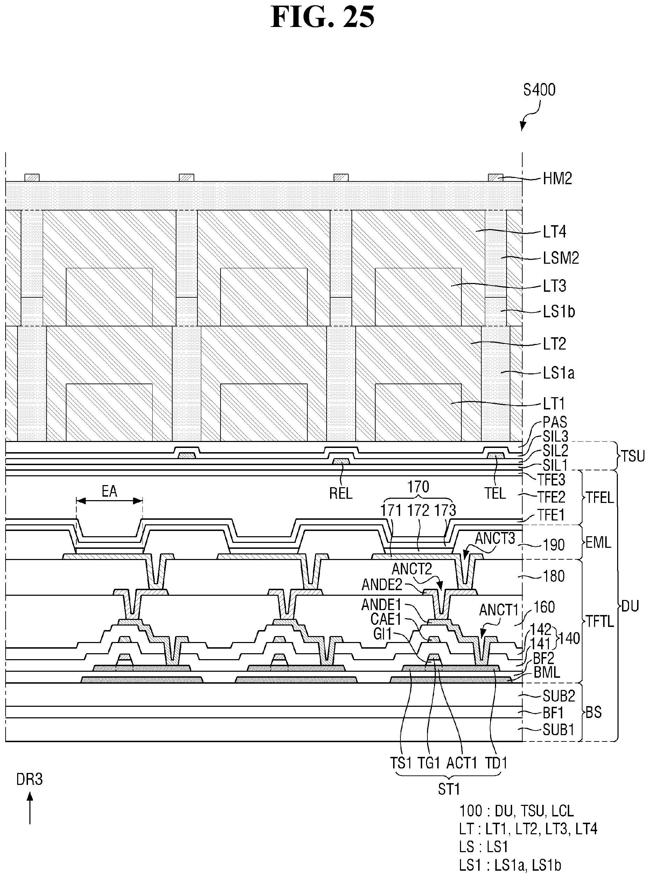

The first metal layer MTL1 and the second metal layer MTL2 may be, respectively, a first hard mask HM1 (see FIG. 21) and a second hard mask HM2 (see FIG. 25), which are used for patterning the light-shielding layer LS in the method S1 (see FIG. 18) for manufacturing a display device, which will be described later. The first metal layer MTL1 and the second metal layer MTL2 may not be removed after the patterning process of the light-shielding layer LS.

Therefore, because a separate strip process for removing the first hard mask HM1 (see FIG. 21) and the second hard mask HM2 (see FIG. 25) does not need to be performed, process efficiency may be relatively improved.

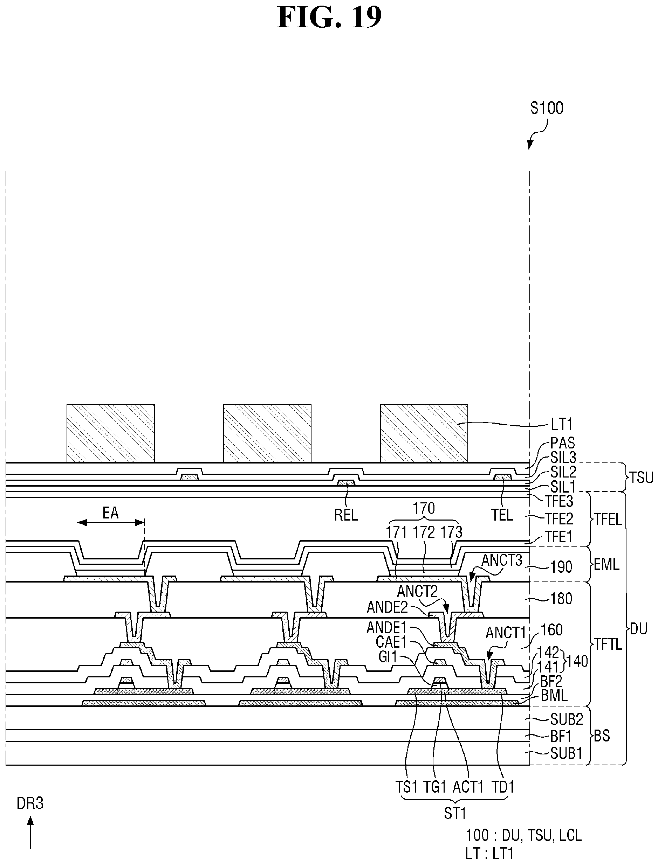

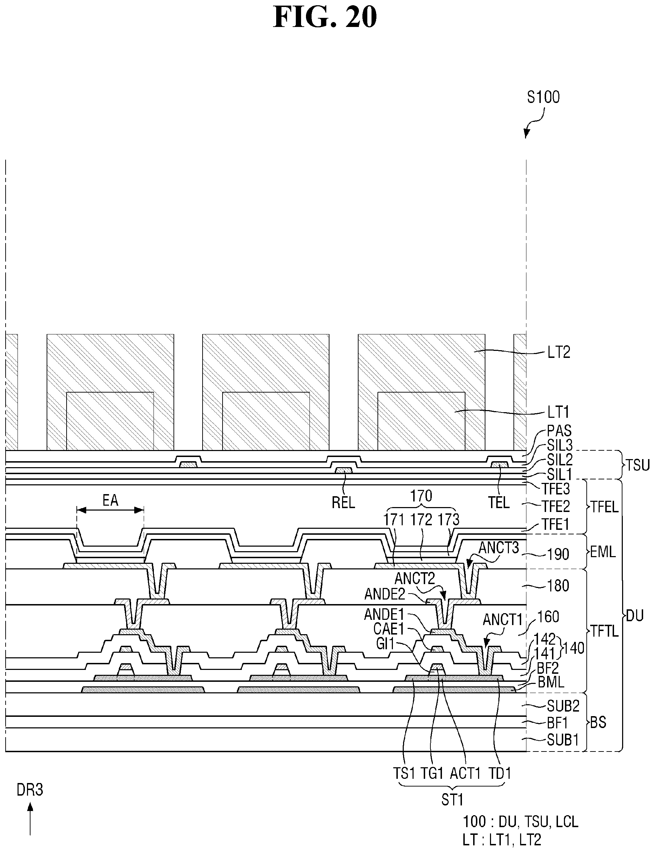

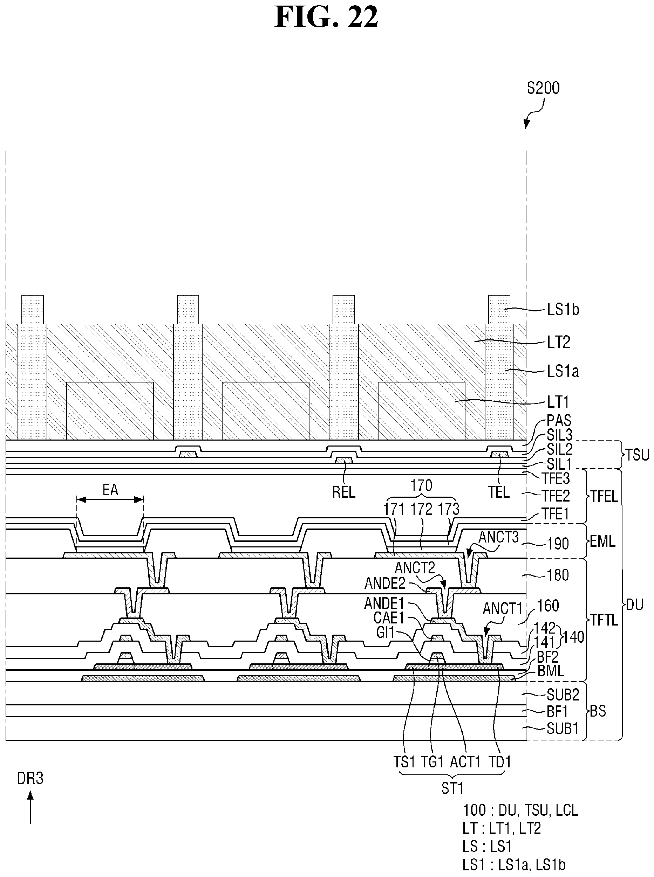

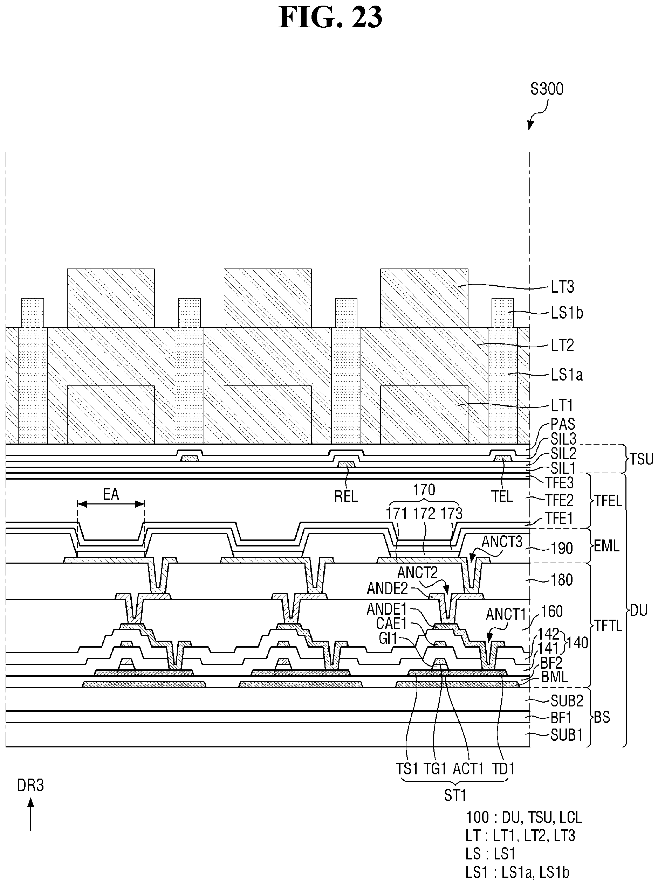

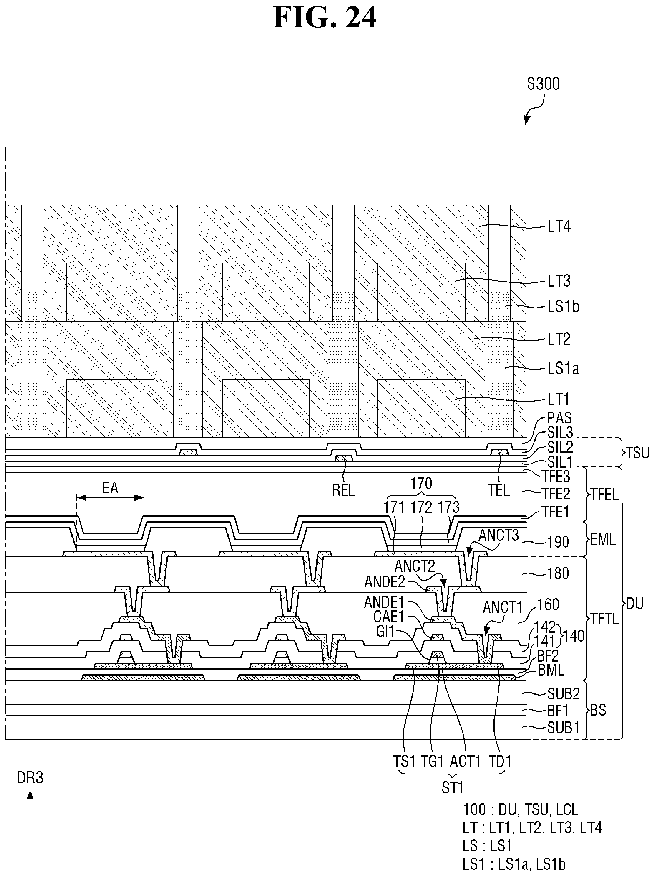

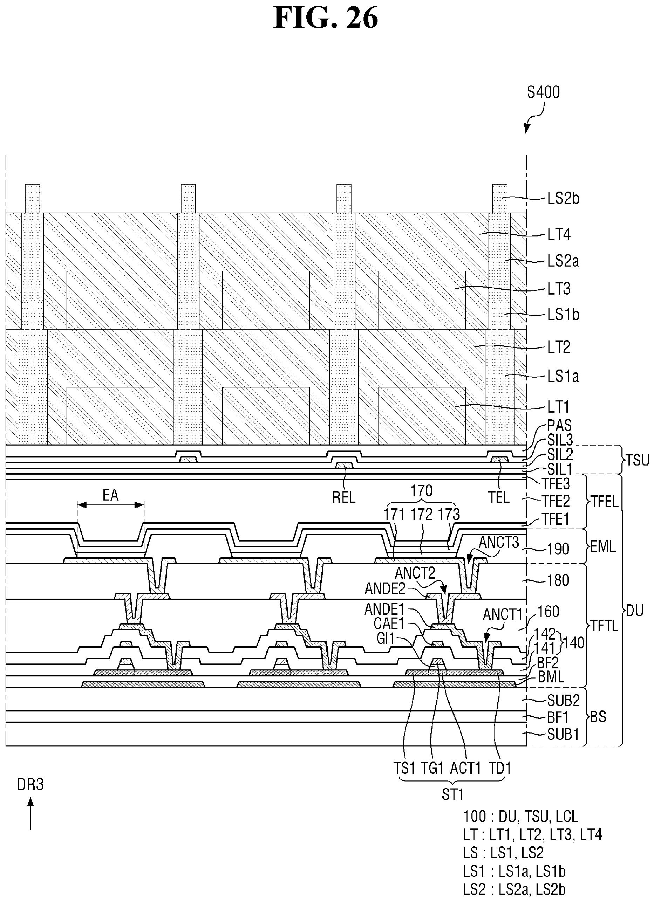

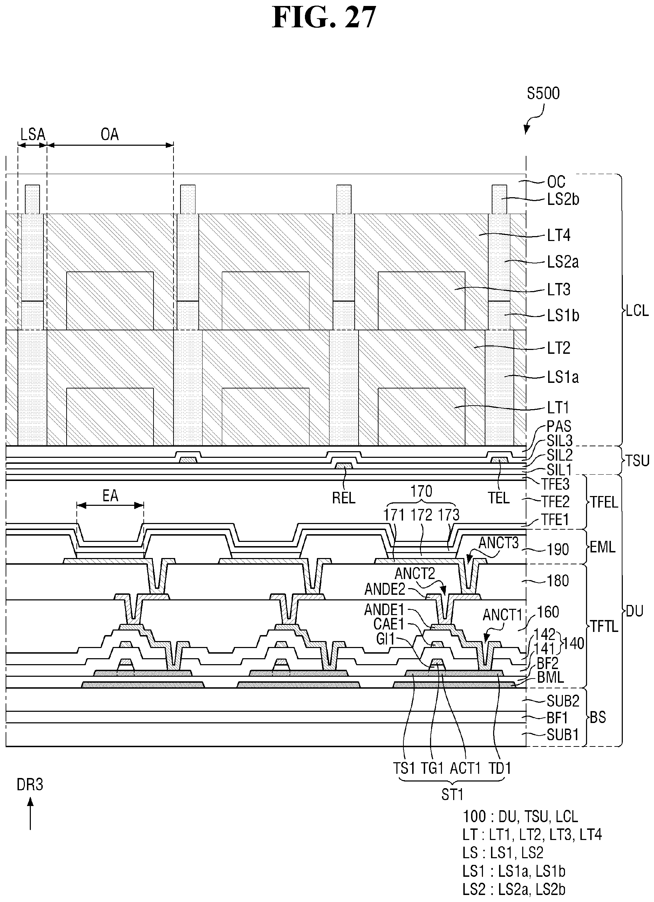

FIG. 18 is a flow chart illustrating a method for manufacturing a display device according to the embodiments of FIG. 8. FIGS. 19 and 20 are cross-sectional views illustrating step S100 of FIG. 18. FIGS. 21 and 22 are cross-sectional views illustrating step S200 of FIG. 18. FIGS. 23 and 24 are cross-sectional views illustrating step S300 of FIG. 18. FIGS. 25 and 26 are cross-sectional views illustrating step S400 of FIG. 18. FIG. 27 is a cross-sectional view illustrating step S500 of FIG. 18.

Referring to FIGS. 18 to 27, the method S1 for manufacturing a display device according to the embodiments of FIG. 8 may include a step S100 of forming a first light-transmitting layer and forming a second light-transmitting layer on the first light-transmitting layer, a step S200 of forming a first light-shielding layer between the second light-transmitting layers, a step S300 of forming a third light-transmitting layer on the second light-transmitting layer and forming a fourth light-transmitting layer on the third light-transmitting layer, a step S400 of forming a second light-shielding layer between the fourth light-transmitting layers, and a step of S500 of forming an overcoat layer on the second light-shielding layer.

First, as shown in FIG. 19, the first light-transmitting layer LT1 may be patterned on the touch sensor layer TSU through the photolithography process in the step S100 of forming the first light-transmitting layer and forming the second light-transmitting layer on the first light-transmitting layer.

For example, a material for forming the first light-transmitting layer LT1 may be located on an entire surface on the touch sensor layer TSU through deposition or the like. Afterwards, an exposure process may be performed for the material for forming the first light-transmitting layer LT1. After the exposure process is performed, the first light-transmitting layer LT1 of a desired pattern may be formed through a development process.

Next, as shown in FIG. 20, a material for forming the second light-transmitting layer LT2 may be formed through deposition or the like, in the same manner as shown in FIG. 19. The material for forming the second light-transmitting layer LT2 may be also filled in a space between the patterned first light-transmitting layers LT as well as the upper surface of the first light-transmitting layer LT1. Afterwards, the exposure and development processes may be performed for the material for forming the second light-transmitting layer LT2, whereby the second light-transmitting layer LT2 may be formed.

Second, as shown in FIG. 21, a first light-shielding material layer LSM1 may be located between the patterned second light-transmitting layers LT2 and on the second light-transmitting layer LT2, in the step S200 of forming the first light-shielding layer between the second light-transmitting layers.

The first light-shielding material layer LSM1 may be filled between the patterned second light-transmitting layers LT2 through a slit coating method, but is not limited thereto. The first light-shielding material layer LSM1 may be filled between the patterned second light-transmitting layers LT2 through a printing method, an inkjet method, deposition or the like.

In the process of filling the first light-shielding material layer LSM1 between the patterned second light-transmitting layers LT2, a portion of the first light-shielding material layer LSM1 may be over-filled and thus located on the second light-transmitting layer LT2.

The first hard mask HM1 may be located on the first light-shielding material layer LSM1 over-filled on the second light-transmitting layer LT2. The first light-shielding material layer LSM1 may be etched using the first hard mask HM1, whereby the first light-shielding layer LS1 may be formed. According to some embodiments, the first light-shielding material layer LSM1 may be etched through dry etching, but is not limited thereto.

As shown in FIG. 22, the first portion LS1a may be formed between the patterned second light-transmitting layers LT2, and the second portion LS1b may be formed on the first portion LS1a.

Third, as shown in FIG. 23, the third light-transmitting layer LT3 may be patterned on the second light-transmitting layer LT2 through the photolithography process in the step S300 of forming the third light-shielding layer on the second light-shielding layer and forming the fourth light-shielding layer on the third light-shielding layer.

For example, a material for forming the third light-transmitting layer LT3 may be located on an entire surface on the second light-transmitting layer LT2 except a portion in which the second portion LS1b is located. Then, exposure may be performed for the material for forming the third light-transmitting layer LT3. The third light-transmitting layer LT3 of a desired pattern may be formed through development after exposure.

Next, as shown in FIG. 24, a material for forming the fourth light-transmitting layer LT4 may be formed through deposition or the like, in the same manner as shown in FIG. 23. The material for forming the fourth light-transmitting layer LT4 may be filled in a space between the patterned third light-transmitting layer LT3 as well as the upper surface of the third light-transmitting layer LT3. Afterwards, exposure and development may be performed for the material for forming the fourth light-transmitting layer LT4, whereby the fourth light-transmitting layer LT4 may be formed.

Fourth, as shown in FIG. 25, a second light-shielding material layer LSM2 may be located between the patterned fourth light-transmitting layers LT4 and on the fourth light-transmitting layer LT4, in the step S400 of forming the second light-shielding layer between the fourth light-transmitting layers.

The second light-shielding material layer LSM2 may be filled between the patterned fourth light-transmitting layers LT4 through a slit coating method, but is not limited thereto. The second light-shielding material layer LSM2 may be filled between the patterned fourth light-transmitting layers LT4 through a printing method, an inkjet method, deposition or the like.

In the process of filling the second light-shielding material layer LSM2 between the patterned fourth light-transmitting layers LT4, a portion of the second light-shielding material layer LSM2 may be over-filled and thus located on the fourth light-transmitting layer LT4.

The second hard mask HM2 may be located on the second light-shielding material layer LSM2 over-filled on the fourth light-transmitting layer LT4. The second light-shielding material layer LSM2 may be etched using the second hard mask HM2 so that the second light-shielding layer LS2 may be formed. According to some embodiments, the second light-shielding material layer LSM2 may be etched through dry etching, but is not limited thereto.

As shown in FIG. 26, the third portion LS2a may be formed between the patterned fourth light-transmitting layers LT4, and the fourth portion LS2b may be formed on the third portion LS2a.

Fifth, as shown in FIG. 27, the overcoat layer OC may be formed on the fourth light-shielding layer LT4 and the fourth portion LS2b in the step S500 of forming the overcoat layer on the second light-shielding layer. The overcoat layer OC may be located on the fourth light-transmitting layer LT4 and the fourth portion LS2b through deposition or the like. The overcoat layer OC may cover the upper surface and the sides of the fourth portion LS2b.

In the method S1 for manufacturing a display device according to the present embodiments, the first to fourth light-transmitting layers LT1, LT2, LT3 and LT4, the first light-shielding layer LS1 and the second light-shielding layer LS2 may be patterned through a photolithography process, so that reliability of the light control layer LCL may be relatively improved.

For example, because the light control layer LCL is formed of a plurality of layers, the time required for removing the light-transmitting layer LT positioned in the non-transmissive area LSA may be minimized or reduced in order to form the light control layer LCL having the same thickness. In addition, because the thickness from which the light-transmitting layer LT positioned in the non-transmissive area LSA is removed is reduced, formation of a bowing profile, which may occur due to isotropy of an etchant, may be minimized or reduced.

Meanwhile, when the light-transmitting layer LT positioned in the non-transmissive area LSA is removed, a photolithography process not dry etching may be used so that the process time and costs may be shortened, whereby process efficiency may be relatively improved. In addition, as the photolithography process is used, the width of the light-shielding layer LS may be more reduced than the case that the light-transmitting layer LT is etched through dry etching. Therefore, the light control layer LCL may be applied to the display device 10 of high resolution. In addition, because patterning is performed through the photolithography process, it is not necessary to remove the light-shielding layer LS, which is over-filled on the upper surface, through a polishing process, whereby the process costs may be reduced.

In concluding the detailed description, those skilled in the art will appreciate that many variations and modifications can be made to the disclosed embodiments without substantially departing from the scope of the claims. Therefore, the disclosed embodiments of the invention are used in a generic and descriptive sense only and not for purposes of limitation.

## Claims

1. A display device (10) comprising:
a substrate (SUB1, SUB2);
a light emitting element layer (EML) on the substrate (SUB1, SUB2), including a plurality of light emitting elements (170) configured to emit light; and
a light control layer (LCL) on the light emitting element layer (EML), including a light-transmitting layer (LT) configured to transmit the light and a light-shielding layer (LS) configured to shield the light,
wherein the light-transmitting layer (LT) includes:
a first light-transmitting layer (LT1);
a second light-transmitting layer (LT2) on the first light-transmitting layer (LT1);
a third light-transmitting layer (LT3) on the second light-transmitting layer (LT2); and
a fourth light-transmitting layer (LT4) on the third light-transmitting layer (LT3),
wherein the first light-transmitting layer (LT1) and the second light-transmitting layer (LT2) form together a first combined light-transmitting layer, and the third light-transmitting layer (LT3) and the fourth light-transmitting layer (LT4) form together a second combined light-transmitting layer;
wherein the light-shielding layer (LS) includes:
a first portion (LS1a) between sections of the first combined light-transmitting layer;
a second portion (LS1b) on the first portion and between sections of the second combined light-transmitting layer;
a third portion (LS2a) on the second portion (LS1b) and between the sections of the second combined light-transmitting layer; and
a fourth portion (LS2b) on the third portion (LS2a).

2. The display device (10) of claim 1,
wherein the first light-transmitting layer (LT1) comprises sections enclosed by the second light-transmitting layer (LT2) such that the second light-transmitting layer (LT2) covers an upper surface and sides of the sections of the first light-transmitting layer (LT1).

3. The display device (10) of claim 1, wherein the second light-transmitting layer (LT2) covers on an upper surface of the first light-transmitting layer (LT1) and is not in contact with sides of the first light-transmitting layer (LT1).

4. The display device (10) of at least one of claims 1 to 3, wherein a width (L1) of the first light-transmitting layer (LT1) is smaller than a width (L2) of the second light-transmitting layer (LT2).

5. The display device (10) of claims 3 and 4, wherein a width (W1a) of a portion of the first portion(LS1a), which portion overlaps the first light-transmitting layer (LT1) in a direction along the substrate (SUB1, SUB2), is greater than a width (W1b) of a portion of the first portion (LS1a), which portion overlaps the second light-transmitting layer (LT2) in a direction along the substrate (SUB1, SUB2).

6. The display device (10) of claim 3, wherein a width (L1) of the first light-transmitting layer (LT1) is greater than a width (L2) of the second light-transmitting layer (LT2).

7. The display device (10) of claim 6, wherein a width (W1a) of a portion of the first portion (LS1a), which portion overlaps the first light-transmitting layer (LT1) in a direction along the substrate (SUB1, SUB2), is smaller than a width (W1b) of a portion of the first portion (LS1a), which portion overlaps the second light-transmitting layer (LT2).

8. The display device (10) of claim 3, wherein a width (L1) of the first light-transmitting layer (LT1) is equal to a width (L2) of the second light-transmitting layer (LT2).

9. The display device (10) of at least one of claims 1 to 3, wherein a width (W1) of the first portion (LS1a) is equal to a width (W2) of the second portion (LS1b).

10. The display device (10) of at least one of claims 1 to 3, wherein a width (W1) of the first portion (LS1a) is greater than a width (W2) of the second portion (LS1b).

11. The display device (10) of at least one of claims 1 to 3, wherein a width (W1) of the first portion (LS1a) is smaller than a width (W2) of the second portion (LS1b).

12. The display device (10) of at least one of claims 1 to 11, wherein a thickness of the first light-transmitting layer (LT1) is smaller than a thickness of the second light-transmitting layer (LT2).

13. The display device (10) of at least one of claims 1 to 12, wherein the width (W2) of the second portion (LS1b) is greater than a width (W4) of the fourth portion (LS2b).

14. The display device (10) of at least one of claims 1 to 12, wherein the width (W2) of the second portion (LS1b) is smaller than a width (W4) of the fourth portion (LS2b).

15. The display device (10) of at least one of claims 1 to 14, wherein sides of at least one of the first to fourth light-transmitting layers (LT1-LT4) or the first to fourth portions (LS1a, LS1b, LS2a, LS2b) are inclined.

16. The display device (10) of at least one of claims 1 to 15, further comprising a first metal layer (MTL1) between the second portion (LS1b) and the third portion (LS2a).
